# EUROPEAN PATENT APPLICATION

(11) **EP 4 564 150 A1**
(43) Date of publication of application: **04.06.2025**
(21) Application number: 23859166.3
(22) Date of filing: 17.08.2023
(51) Int. Cl.: G06F 3/06

(54) **DATA STORAGE METHOD AND RELATED APPARATUS**

(30) Priority: 29.08.2022 CN 202211048641
(71) Applicant: Huawei Technologies Co., Ltd., Shenzhen, Guangdong 518129 (CN)
(72) Inventor: CHENG, Xizhe, Shenzhen, Guangdong 518129 (CN); YANG, Meng, Shenzhen, Guangdong 518129 (CN); JI, Dedong, Shenzhen, Guangdong 518129 (CN); YAN, Min, Shenzhen, Guangdong 518129 (CN); SUN, Jie, Shenzhen, Guangdong 518129 (CN)
(74) Representative: Gill Jennings & Every LLP
(86) International application number: PCT/CN2023/113437
(87) International publication number: WO 2024/046132

(57) **Abstract**

This application provides a data storage method and a related apparatus. The method includes: obtaining a first data page and a second data page in a database; compressing the first data page and the second data page, to obtain a first compressed data page and a second compressed data page; and storing, in a first storage unit in a storage, all or partial data of the first compressed data page and all or partial data of the second compressed data page. In this way, one storage unit in the storage can store different compressed data pages, thereby improving utilization of storage space of the storage unit in the storage.

## Description

This application claims priority to Chinese Patent Application No. 202211048641.5, filed with the China National Intellectual Property Administration on August 29, 2022 and entitled "DATA STORAGE METHOD AND RELATED APPARATUS", which is incorporated herein by reference in its entirety.

### TECHNICAL FIELD

This application relates to the field of data storage technologies, and in particular, to a data storage method and a related apparatus.

### BACKGROUND

With the rapid development of big data, cloud computing, and an internet of things, an amount of data increases exponentially, and more storage space is needed to store the data. Therefore, database storage technologies are also developing rapidly.

Data compression algorithms serve as an optimization for database storage, and aim to compress data for storage, so that more data can be stored by using same hardware resources. Therefore, how to improve performance and a compression rate of a data compression algorithm of a database needs to be further studied.

### SUMMARY

This application provides a data storage method and a related apparatus, so that one storage unit in a storage can store different compressed data pages, thereby improving utilization of storage space of the storage unit in the storage, and avoiding a waste of storage space caused by a case in which only one compressed data page can be stored in one storage unit currently.

According to a first aspect, this application provides a data storage method. The method includes: obtaining a first data page and a second data page in a database; compressing the first data page and the second data page, to obtain a first compressed data page and a second compressed data page; and storing, in a first storage unit in a storage, all or partial data of the first compressed data page and all or partial data of the second compressed data page.

According to the method provided in the first aspect, one storage unit in the storage can store different compressed data pages, thereby improving utilization of storage space of the storage unit in the storage.

With reference to the first aspect, in a possible implementation, after the first compressed data page and the second compressed data page are obtained, and before the jointly storing, in a first storage unit in a storage, all or partial data of the first compressed data page and all or partial data of the second compressed data page, the method further includes: splitting the first compressed data page into a first chunk and a second chunk; and splitting the second compressed data page into a third chunk and a fourth chunk; and the storing, in a first storage unit in a storage, all or partial data of the first compressed data page and all or partial data of the second compressed data page specifically includes: storing, in the first storage unit in the storage, the first chunk and/or the second chunk, and the third chunk and/or the fourth chunk.

Optionally, the first compressed data page and the second compressed data page may be split into more or fewer chunks. This is not limited in this embodiment of this application. A compressed data page is split into chunks, so that a plurality of different compressed data pages may be stored in parallel in the storage, thereby reducing data storage time. In addition, it is convenient to allocate storage space of the storage unit in the storage.

With reference to the first aspect, in a possible implementation, storage space of the first storage unit is an integer multiple of a chunk. In this way, it is convenient to allocate storage space of the storage unit in the storage.

With reference to the first aspect, in a possible implementation, after the storing, in the first storage unit in the storage, the first chunk and/or the second chunk, and the third chunk and/or the fourth chunk, the method further includes: storing, in a second storage unit in the storage, a correspondence between the first compressed data page, and a location of the first chunk and a location of the second chunk, and a correspondence between the second compressed data page, and a location of the third chunk and a location of the fourth chunk.

In some embodiments, a location of a chunk may be understood as a direct storage location of the chunk in the storage, that is, a storage location of the chunk in a storage unit in the storage. For example, the location of the chunk may be storage locations of a 1^{st} KB and a 2^{nd} KB in the first storage unit in the storage.

In some embodiments, a location of a chunk may alternatively be understood as an indirect storage location of the chunk in the storage,
that is, a location of the chunk in an extent in which a compressed data page is located, and a storage location of the extent in which the compressed data page is located in a storage unit in the storage. A plurality of compressed data pages stored in the extent may be obtained based on the storage location of the extent in which the compressed data page is located in the storage unit in the storage, and then a compressed data page corresponding to the chunk is determined based on the location of the chunk in the extent in which the compressed data page is located.

The correspondence may also be referred to as PCA information. The PCA information is stored in the second storage unit in the storage, to facilitate subsequent search for a compressed data page.

With reference to the first aspect, in a possible implementation, when the first storage unit stores the first chunk and the second chunk, after the storing, in the first storage unit in the storage, the first chunk and/or the second chunk, and the third chunk and/or the fourth chunk, the method further includes: obtaining a request for managing the first data page, where the request for managing the first data page includes but is not limited to adding data to the first data page, reading data on the first data page, modifying data on the first data page, and deleting and modifying data on the first data page; obtaining, from the second storage unit, an identifier of the first chunk and an identifier of the second chunk that correspond to the first compressed data page; determining the location of the first chunk in the first storage unit based on the identifier of the first chunk, and determining the location of the second chunk in the first storage unit based on the identifier of the second chunk; obtaining the first compressed data page based on the location of the first chunk in the first storage unit and the location of the second chunk in the first storage unit; and decompressing the first compressed data page to obtain the first data page.

When a compressed data page is searched for, a direct storage location of a chunk in the storage or an indirect storage location of the chunk in the storage may be directly found from the PCA information. In this way, the compressed data page is found. This is convenient and fast.

With reference to the first aspect, in a possible implementation, the compressing the first data page to obtain a first compressed data page specifically includes: splitting the first data page into a first data part and a second data part; compressing the first data part according to a first compression algorithm, to obtain a first compressed data stream; compressing the second data part according to a second compression algorithm, to obtain a second compressed data stream; and merging the first compressed data stream and the second compressed data stream, to obtain the first compressed data page, where the first compression algorithm is different from the first compressed data stream.

It should be noted that the first data page may be further split into more data parts. For example, the split data parts further include a third data part and a fourth data part.

Different data on a data page is compressed according to different compression algorithms, so that a compression rate of the data page can be improved.

With reference to the first aspect, in a possible implementation, the first data part is metadata, and the second data part is tuple data; the metadata indicates a feature of the first data page, and the tuple data indicates data stored in the first data page; the compressing the first data part according to a first compression algorithm, to obtain a first compressed data stream specifically includes: compressing the metadata according to the first compression algorithm, to obtain the first compressed data stream; and the compressing the second data part according to a second compression algorithm, to obtain a second compressed data stream specifically includes: compressing the tuple data according to the second compression algorithm, to obtain the second compressed data stream.

Optionally, the third data part may be free space data, and the fourth data part may be special space data.

Optionally, the first compression algorithm may be an LZ4 compression algorithm, and the second compression algorithm may be the LZ4 compression algorithm or a Huffman compression algorithm.

With reference to the first aspect, in a possible implementation, the compressing the tuple data according to the second compression algorithm, to obtain the second compressed data stream specifically includes: splitting the tuple data into a first part of the tuple data and a second part of the tuple data, where the first part of the tuple data includes the first m bytes of each piece of tuple data, and the second part of the data includes the last n bytes of each piece of tuple data; compressing the first part of the tuple data according to the LZ4 compression algorithm, to obtain a first part of compressed tuple data; compressing the second part of the tuple data according to the Huffman compression algorithm, to obtain a second part of the compressed tuple data; and merging the first part of the compressed tuple data and the second part of the compressed tuple data, to obtain the second compressed data stream.

The tuple data may be further split into different data, and different data is compressed according to different compression algorithms, so that a compression rate of the tuple data can be improved.

With reference to the first aspect, in a possible implementation, the splitting the tuple data into a first part of the tuple data and a second part of the tuple data specifically includes: when the tuple data on the first compressed data page is greater than a first value, splitting the tuple data into the first part of the tuple data and the second part of the tuple data.

When the tuple data on the first compressed data page is less than the first value, for example, when the tuple data has only one row, it is unnecessary to split the tuple data, and a compression rate of the tuple data after splitting is similar to a compression rate of the tuple data before splitting.

According to a second aspect, this application provides an apparatus. The apparatus includes an obtaining unit, a compression unit, and a processing unit. The obtaining unit is configured to obtain a first data page and a second data page in a database. The compression unit is configured to compress the first data page and the second data page, to obtain a first compressed data page and a second compressed data page. The processing unit is configured to store, in a first storage unit in a storage, all or partial data of the first compressed data page and all or partial data of the second compressed data page.

With reference to the second aspect, in a possible implementation, the compression unit is further configured to: split the first compressed data page into a first chunk and a second chunk; and split the second compressed data page into a third chunk and a fourth chunk.

The processing unit is specifically configured to store, in the first storage unit in the storage, the first chunk and/or the second chunk, and the third chunk and/or the fourth chunk.

With reference to the second aspect, in a possible implementation, storage space of the first storage unit is an integer multiple of a chunk. In this way, it is convenient to allocate storage space of the storage unit in the storage.

With reference to the second aspect, in a possible implementation, the processing unit is further configured to store, in a second storage unit in the storage, a correspondence between the first compressed data page, and a location of the first chunk and a location of the second chunk, and a correspondence between the second compressed data page, and a location of the third chunk and a location of the fourth chunk.

With reference to the second aspect, in a possible implementation, when the first storage unit stores the first chunk and the second chunk, the processing unit is further configured to: obtain a request for managing the first data page, where the request for managing the first data page includes but is not limited to adding data to the first data page, reading data on the first data page, modifying data on the first data page, and deleting and modifying data on the first data page; obtain, from the second storage unit, an identifier of the first chunk and an identifier of the second chunk that correspond to the first compressed data page; determine the location of the first chunk in the first storage unit based on the identifier of the first chunk, and determine the location of the second chunk in the first storage unit based on the identifier of the second chunk; obtain the first compressed data page based on the location of the first chunk in the first storage unit and the location of the second chunk in the first storage unit; and decompress the first compressed data page to obtain the first data page.

With reference to the second aspect, in a possible implementation, the compression unit is specifically configured to: split the first data page into a first data part and a second data part; compress the first data part according to a first compression algorithm, to obtain a first compressed data stream; compress the second data part according to a second compression algorithm, to obtain a second compressed data stream; and merge the first compressed data stream and the second compressed data stream, to obtain the first compressed data page, where the first compression algorithm is different from the first compressed data stream.

With reference to the second aspect, in a possible implementation, the first data part is metadata, and the second data part is tuple data; the metadata indicates a feature of the first data page, and the tuple data indicates data stored in the first data page; and the compression unit is specifically configured to: compress the metadata according to the first compression algorithm, to obtain the first compressed data stream; and compress the tuple data according to the second compression algorithm, to obtain the second compressed data stream.

With reference to the second aspect, in a possible implementation, the compression unit is specifically configured to: split the tuple data into a first part of the tuple data and a second part of the tuple data, where the first part of the tuple data includes the first m bytes of each piece of tuple data, and the second part of the data includes the last n bytes of each piece of tuple data; compress the first part of the tuple data according to the LZ4 compression algorithm, to obtain a first part of compressed tuple data; compress the second part of the tuple data according to the Huffman compression algorithm, to obtain a second part of the compressed tuple data; and merge the first part of the compressed tuple data and the second part of the compressed tuple data, to obtain the second compressed data stream.

With reference to the second aspect, in a possible implementation, the compression unit is specifically configured to: when the tuple data on the first compressed data page is greater than a first value, split the tuple data into the first part of the tuple data and the second part of the tuple data.

According to a third aspect, this application provides a data storage apparatus. The apparatus includes a processor and a storage, the storage is coupled to the processor, the storage is configured to store computer program code, the computer program code includes computer instructions, and the processor invokes the computer instructions to perform the data storage method provided in any possible implementation of any one of the foregoing aspects.

According to a fourth aspect, this application provides a computer-readable storage medium, configured to store computer instructions. When the computer instructions are run on a computer, the computer is enabled to perform the data storage method provided in any possible implementation of any one of the foregoing aspects.

According to a fifth aspect, this application provides a computer program product. When the computer program product runs on a computer, the computer is enabled to perform the data storage method according to any possible implementation of any one of the foregoing aspects.

For beneficial effects of the second aspect to the fifth aspect, refer to descriptions of beneficial effects in the first aspect. Details are not described herein again in embodiments of this application.

### BRIEF DESCRIPTION OF DRAWINGS

FIG. 1 is a diagram of a structure of a data page in a database according to an embodiment of this application;
FIG. 2 is a diagram of data storage according to an embodiment of this application;
FIG. 3 is another diagram of data storage according to an embodiment of this application;
FIG. 4 is a diagram of functional modules according to an embodiment of this application;
FIG. 5 is a diagram of how to compress a data page in a database according to an embodiment of this application;
FIG. 6 is a diagram of different compression algorithms according to an embodiment of this application;
FIG. 7 to FIG. 10 are a group of diagrams according to embodiments of this application;
FIG. 11 is a diagram of a manner of performing data merging on a first part of tuple data according to an embodiment of this application;
FIG. 12 is a diagram of another manner of performing data merging on a first part of tuple data according to an embodiment of this application;
FIG. 13 is a diagram of storing a compressed data page in a storage unit according to an embodiment of this application;
FIG. 14 is another diagram of storing a compressed data page in a storage unit according to an embodiment of this application;
FIG. 15 is still another diagram of storing a compressed data page in a storage unit according to an embodiment of this application;
FIG. 16 is a schematic flowchart of a data storage method according to an embodiment of this application;
FIG. 17 is a schematic flowchart of a data storage apparatus according to an embodiment of this application; and
FIG. 18 is a schematic flowchart of another data storage apparatus according to an embodiment of this application.

### DESCRIPTION OF EMBODIMENTS

Technical solutions according to embodiments of this application are clearly and completely described in the following with reference to accompanying drawings. In descriptions of embodiments of this application, unless otherwise specified, "/" represents "or". For example, A/B may represent A or B. In this specification, "and/or" describes only an association relationship between associated objects, and represents that three relationships may exist. For example, A and/or B may represent the following three cases: Only A exists, both A and B exist, and only B exists. In addition, in the descriptions of embodiments of this application, "a plurality of" means two or more.

The following terms "first" and "second" are merely intended for a purpose of description, and shall not be understood as an indication or implication of relative importance or implicit indication of a quantity of indicated technical features. Therefore, a feature limited by "first" and "second" may explicitly or implicitly include one or more features. In the descriptions of embodiments of this application, unless otherwise specified, "a plurality of" means two or more.

First, technical terms in embodiments of this application are explained.

### 1. Database

A database is a method and technology for organizing, storing, and managing data based on a data structure. The database may store the data in a storage in an orderly manner according to a rule, thereby improving efficiency of storing data, searching for data, reading data, and deleting data in the storage.

A data page is a minimum storage unit in the database, and data stored in the database is stored in the data page of the database. The data page has a fixed size. For example, a size of each data page in the database may be 8 KB. When the data in the database is stored in the storage, the data in the database is stored in the storage in a form of a data page.

The data page is also a minimum operation unit in the database. When the data in the database needs to be modified, a data page on which the data is located needs to be first found, the data page is read and stored in a memory, and then the data on the data page is modified. After modification is complete, a modified data page is stored in an original storage location in the database.

### 2. Data page in a database

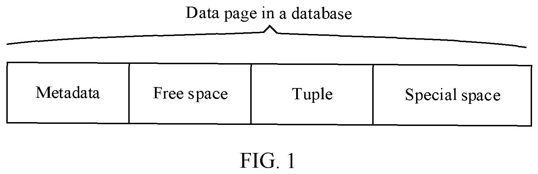

FIG. 1 shows a diagram of a structure of a data page in a database.

As shown in FIG. 1, the data page includes metadata, free space data, tuple data, and special space data. In another embodiment, composition of a database may be different. This is not limited in embodiments of this application.

The metadata indicates a feature of the data page, for example, a file number and a page number of the data page in the database, a file number and a page number of a next data page of the data page in the database, a total quantity of slots (rows) occupied by the data page, a length of each row of data (or referred to as a length (len) of each piece of tuple data), a distance or an offset (offset) between each tuple and a table header, a flag bit or a flag (flag) of each tuple, or the like.

Free space is storage space reserved in the data page, so that data can be subsequently added to the data page in the storage space provided by the free space.

The tuple data is tuple data, each record on the data page is a tuple, and the tuple may also be referred to as a row. In other words, each row of data on the data page is one piece of tuple data. The tuple data indicates data stored in the data page, and the tuple data is a most important part of the data page. If the data page includes n records, the data page may include n tuples. For example, an n-tuple may be represented as (d1, d2, d3, d4, ..., dn).

The special space data is a last idle part of the data page, so that data can be subsequently added to special space.

It should be noted that FIG. 1 merely shows an example of the structure of the data page in the database. In another embodiment, a structure of a data page in a database may be different from that in FIG. 1. This is not limited in embodiments of this application. Embodiments of this application are described by merely using a composition structure that is of the data page and that is shown in FIG. 1 as an example.

When data pages in the database are stored in a storage, the data pages may be stored in the storage in a unit of a single data page, or may be stored in the storage in groups by using a plurality of data pages as a group. In some embodiments, the group may also be referred to as an extent.

When a data page stored in the storage needs to be searched for, and data pages are stored in the storage in the unit of a single data page, the data page that needs to be searched for may be found in the storage based on an identifier of the data page that needs to be searched for. Alternatively, when a plurality of data pages are stored in the storage as a group, a group in which the data page that needs to be searched for is located may be found in the storage based on the identifier of the data page that needs to be searched for, and then the data page that needs to be searched for is found in the group.

Alternatively, data pages may be stored and searched in another manner. This is not limited in embodiments of this application.

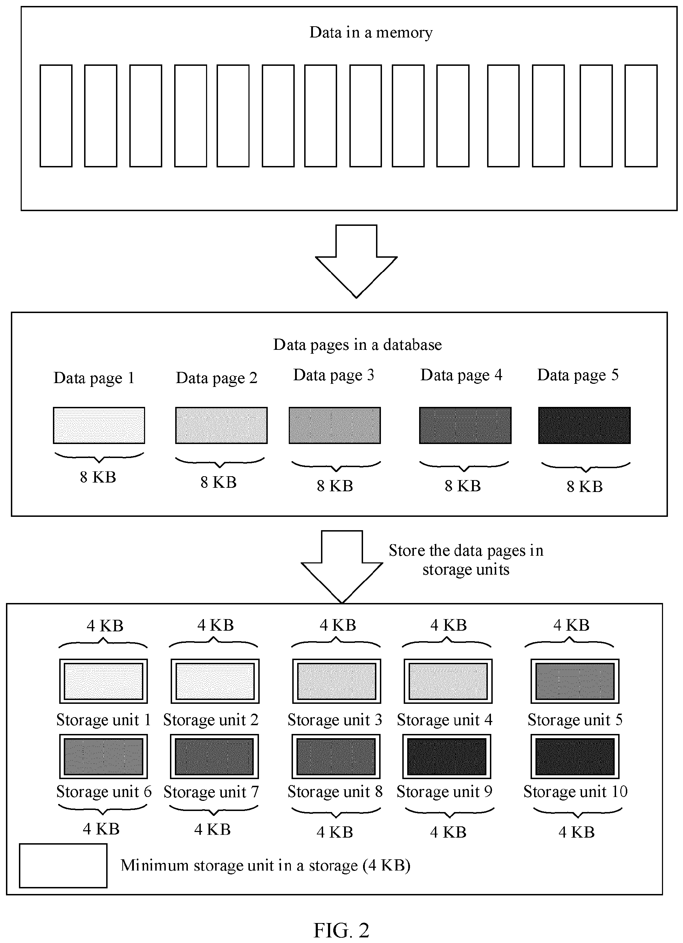

FIG. 2 shows a diagram of data storage.

As shown in FIG. 2, data in a memory is stored in a database, and a data page is used as a minimum storage unit to store data in the database. For example, a size of the data page in the database may be 8 KB. The size of the data page in the database may alternatively be another value. This is not limited in embodiments of this application. The following embodiments of this application are described by using an example in which a size of a data page in a database is 8 KB.

In FIG. 2, graphs in different colors in the database represent different data pages. For example, a data page 1, a data page 2, a data page 3, a data page 4, and a data page 5 are sequentially arranged from left to right. The database may further include more or fewer other data pages. This is not limited in embodiments of this application. Sizes of the data page 1, the data page 2, the data page 3, the data page 4, and the data page 5 are all 8 KB.

The data pages in the database are stored in a storage. A size of a minimum storage unit in the storage may be 4 KB. In another embodiment, a size of a minimum storage unit in a storage may alternatively be another value. This is not limited in embodiments of this application. The following embodiments of this application are described by using an example in which a size of a minimum storage unit in a storage is 4 KB.

In FIG. 2, a size of a data page shown is 8 KB, and a size of a minimum storage unit in the storage is 4 KB. Therefore, one data page in the database needs to occupy two storage units in the storage. For example, the data page 1 is stored in a storage unit 1 and a storage unit 2 in the storage, the data page 2 is stored in a storage unit 3 and a storage unit 4 in the storage, the data page 3 is stored in a storage unit 5 and a storage unit 6 in the storage, the data page 4 is stored in a storage unit 7 and a storage unit 8 in the storage, and the data page 5 is stored in a storage unit 9 and a storage unit 10 in the storage.

In the data storage method shown in FIG. 2, data in the database is stored in the storage without being compressed. However, this manner wastes storage space of the storage. To improve utilization of the storage space of the storage, the data in the database is usually compressed, and then compressed data is stored in the storage. In this way, utilization of the storage space of the storage can be improved.

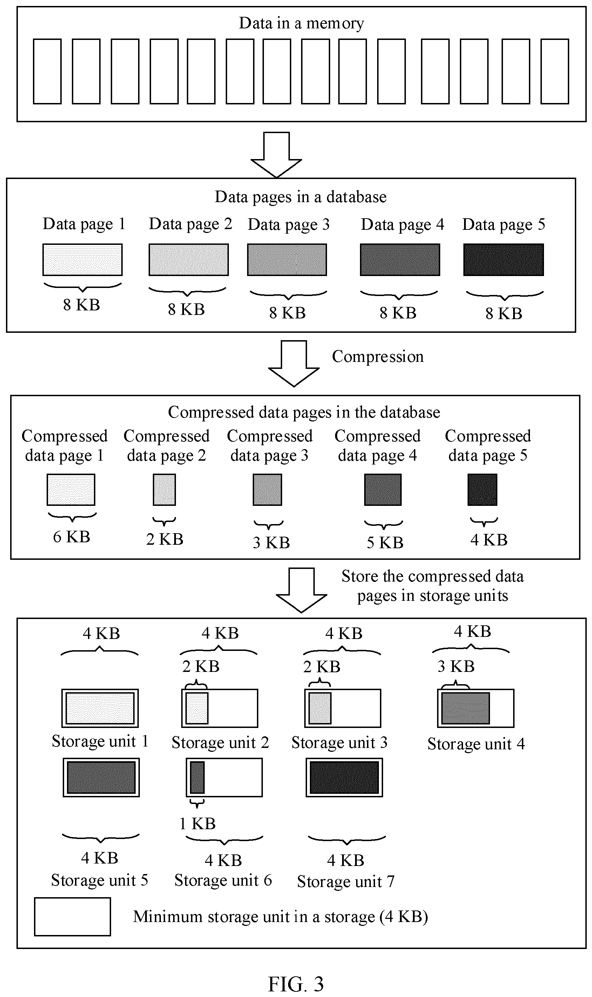

FIG. 3 shows another diagram of data storage.

As shown in FIG. 3, after data in a memory is stored in a database, and before the data in the database is stored in a storage, the data in the database is first compressed, to obtain compressed data. For example, in FIG. 3, a data page 1, a data page 2, a data page 3, a data page 4, and a data page 5 are compressed respectively, to obtain a compressed data page 1, a compressed data page 2, a compressed data page 3, a compressed data page 4, and a compressed data page 5. A size of the compressed data page 1 is 6 KB, and compared with that before compression, the size of the data page 1 is reduced by 2 KB. A size of the compressed data page 2 is 2 KB, and compared with that before compression, the size of the data page 2 is reduced by 6 KB. A size of the compressed data page 3 is 3 KB, and compared with that before compression, the size of the data page 3 is reduced by 5 KB. A size of the compressed data page 4 is 5 KB, and compared with that before compression, the size of the data page 4 is reduced by 3 KB. A size of the compressed data page 5 is 4 KB, and compared with that before compression, the size of the data page 5 is reduced by 4 KB.

After data pages are compressed, if a compressed data page is less than 4 KB, the compressed data page needs to occupy one storage unit in the storage. If a size of a compressed data page is greater than 4 KB and less than 8 KB, the compressed data page needs to occupy two storage units in the storage. As shown in FIG. 3, the compressed data page 1 is stored in a storage unit 1 and a storage unit 2 in the storage, only 2 KB is occupied in the storage unit 2, and remaining 2 KB in the storage unit 2 is not used. The compressed data page 2 is stored in a storage unit 3 in the storage, only 2 KB is occupied in the storage unit 3, and remaining 2 KB in the storage unit 3 is not used. The compressed data page 3 is stored in a storage unit 4 in the storage, only 3 KB is occupied in the storage unit 4, and remaining 1 KB in the storage unit 4 is not used. The compressed data page 4 is stored in a storage unit 5 and a storage unit 6 in the storage, only 1 KB is occupied in the storage unit 6, and remaining 3 KB in the storage unit 6 is not used. The compressed data page 5 is stored in a storage unit 7 in the storage.

It can be learned from FIG. 3 and FIG. 2 that storing a data page in the storage after compressing the data page can reduce storage units occupied by the stored data, and compared with data before being compressed, the data occupies three fewer storage units after compression, thereby improving utilization of storage space of the storage. However, it can be seen from FIG. 3 that, only some storage space in the storage unit 2, the storage unit 3, the storage unit 4, and the storage unit 6 stores data, and remaining storage space is not used, resulting in a waste of storage space.

Based on the foregoing analysis, this application provides a data storage method. The method includes the following steps.

Step 1: Obtain a data page in a database.

Step 2: Compress the data page in the database, to obtain a compressed data page. Compressed data pages may include a compressed data page 1 and a compressed data page 2.

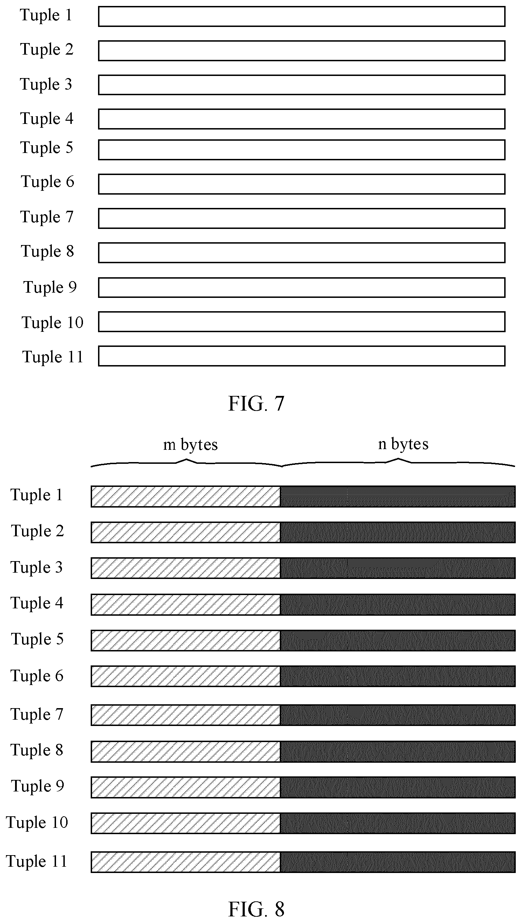

Optionally, the data page may be split into different data parts based on a data feature included in the data page. Different compression algorithms may be used on different data parts, to improve a compression rate. For details, refer to subsequent embodiments shown in FIG. 7 to FIG. 12. Details are not described herein in this embodiment of this application.

Optionally, when obtained to-be-processed data is not a data page in the database, the to-be-processed data may be compressed according to a general compression algorithm, to obtain compressed to-be-processed data. General compression algorithms include but are not limited to a Zstandard compression algorithm, an LZ4 compression algorithm, a GZip compression algorithm, and the like.

Step 3: After the compressed data page is obtained, store, in a storage unit 1 in a storage, all data of the compressed data page 1 and all data of the compressed data page 2, or store, in a storage unit 1 in a storage, all data of the compressed data page 1 and partial data of the compressed data page 2.

In this way, one storage unit in the storage may store different compressed data pages, thereby improving utilization of storage space of the storage unit in the storage, and avoiding a waste of storage space caused by a case in which only one compressed data page can be stored in one storage unit currently.

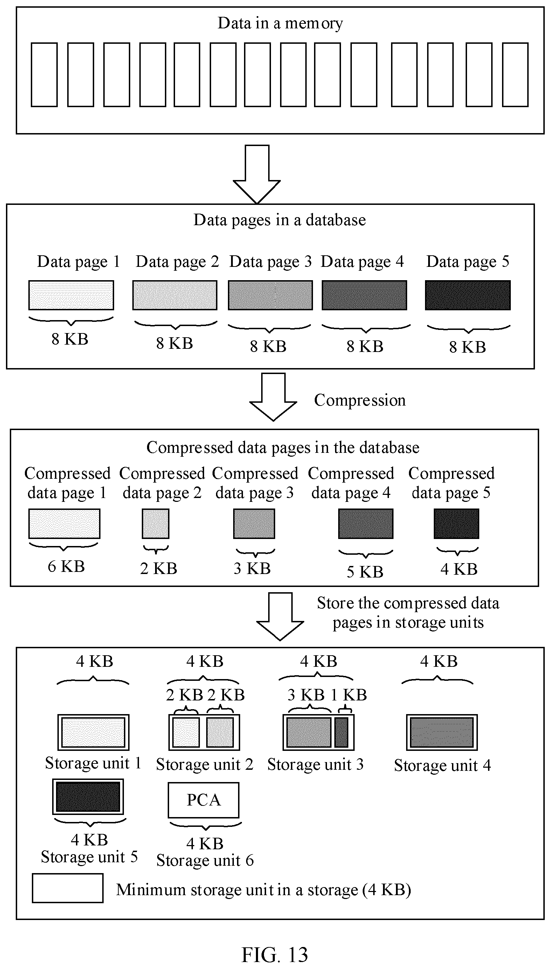

Optionally, when different compressed data pages are stored in one storage unit, to facilitate subsequent management of the different compressed data pages stored in the storage unit, the compressed data pages are first split into one or more chunks, and then the chunks are stored in the storage unit. A chunk has a fixed size, and storage space of the storage unit in the storage is an integer multiple of the chunk. In addition, a correspondence between a storage location of the chunk and the compressed data page is recorded in the storage unit. This facilitates allocation of the storage space of the storage unit and subsequent management of the compressed data page. For how to split a compressed data page into one or more chunks, how to store the chunks in a storage unit, and how to establish a correspondence between a storage location of the chunk and the compressed data page, refer to subsequent embodiments shown in FIG. 13 to FIG. 15. Details are not described herein in this embodiment of this application.

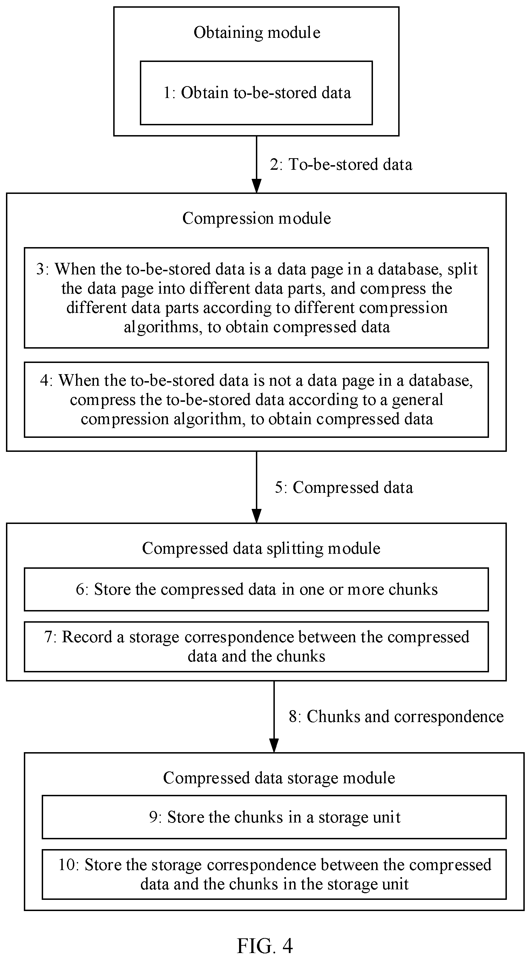

FIG. 4 is a diagram of functional modules according to an embodiment of this application.

The functional modules include but are not limited to an obtaining module, a compression module, a compressed data splitting module, and a compressed data storage module.

The obtaining module is configured to obtain to-be-stored data. The to-be-stored data may be data in a memory. This is not limited in this embodiment of this application.

The obtaining module is further configured to send the to-be-stored data to the compression module.

The compression module is configured to compress the to-be-stored data, to reduce storage space occupied by the to-be-stored data.

Specifically, when the to-be-stored data is a data page in a database, the compression module splits the data page into different data parts, and compresses the different data parts according to different compression algorithms, to obtain compressed data. In this way, a compression rate can be improved. For how to split the data and compress the different data parts, refer to subsequent embodiments shown in FIG. 7 to FIG. 12. Details are not described herein in this embodiment of this application.

When the to-be-stored data is not a data page in the database, the compression module cannot split the to-be-stored data, and the compression module may compress the to-be-stored data according to a general compression algorithm, to obtain compressed data.

The compression module is further configured to: after obtaining the compressed data, send the compressed data to the compressed data splitting module.

The compressed data splitting module is configured to: receive the compressed data sent by the compression module, and split the compressed data into chunks of a fixed size, to facilitate subsequent proper allocation of storage space in the storage.

The compressed data splitting module is further configured to: after splitting the compressed data into the chunks of the fixed size, record a correspondence between the compressed data and the chunks, to facilitate subsequent search for the compressed data.

The compressed data splitting module is further configured to send, to the compressed data storage module, the chunks and the correspondence between the compressed data and the chunks.

The compressed data storage module is configured to: after receiving the chunks and the correspondence between the compressed data and the chunks that are sent by the compressed data splitting module, store the chunks in a storage unit. A size of the storage unit is an integer multiple of a size of a chunk. In this way, all storage space in the storage unit is used.

The compressed data storage module is further configured to store the correspondence between the compressed data and the chunks in the storage unit. When the compressed data needs to be accessed subsequently, the chunks corresponding to the compressed data that needs to be accessed may be found based on the correspondence that is between the compressed data and the chunks and that is stored in the storage unit, and then the compressed data is read from a storage location of the chunks in the storage unit. In this way, it is convenient to manage the chunks and the compressed data.

Embodiments of this application provide a method for compressing a data page in a database. The data page in the database may be split into different data parts, and the different data parts may use a same compression algorithm. In this way, a compression rate can be improved while ensuring compression performance.

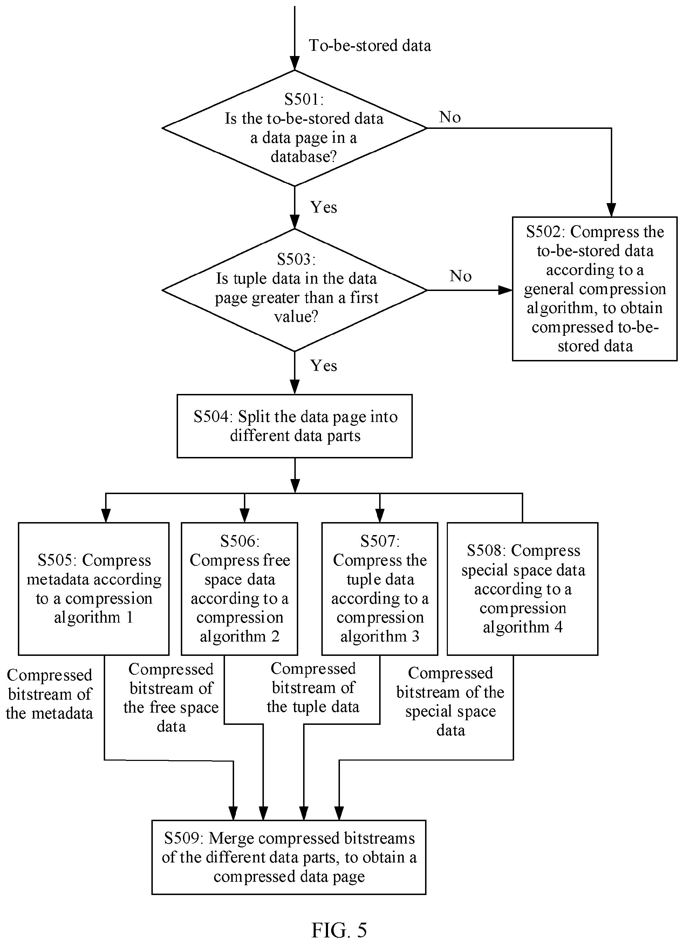

FIG. 5 shows a diagram of how to compress the data page in the database.

Optionally, as shown in FIG. 1, the data page in the database may include metadata, free space data, tuple data, and special space. In another embodiment, composition of a database may be different. This is not limited in embodiments of this application. Embodiments of this application are described by merely using a composition structure that is of the data page and that is shown in FIG. 1 as an example.

S501: Receive to-be-stored data, and determine whether the to-be-stored data is a data page in the database.

When it is determined that the to-be-stored data is not a data page in the database, S502 is performed. When it is determined that the to-be-stored data is a data page in the database, S503 is performed.

S502: Compress the to-be-stored data according to a general compression algorithm, to obtain compressed to-be-stored data.

The to-be-stored data is compressed as a whole according to the general compression algorithm, and the to-be-stored data is no longer split or compressed, to obtain the compressed to-be-stored data.

S503: After it is determined that the to-be-stored data is a data page in the database, determine whether tuple data included in the data page is greater than a first value.

If the tuple data included in the data page is less than the first value, S502 is performed.

If the tuple data included in the data page is greater than the first value, S504 is performed.

The tuple data is a main component of the data page. Therefore, improving a compression rate of the data page in the database is mainly improving a compression rate of the tuple data on the data page. When the tuple data included in the data page is less than the first value, a compression rate in a case in which the data page is split into different data parts and then compressed is equivalent to a compression rate in a case in which the data page is directly compressed without being split. Therefore, when the tuple data included in the data page is less than the first value, and compression rates of the two manners are equivalent, the to-be-stored data may be directly compressed according to the general compression algorithm, to obtain the compressed to-be-stored data, so that a step of splitting the data page into the different data parts may be omitted.

Optionally, S503 may not be performed. After it is determined that the to-be-stored data is a data page in the database, S504 is directly performed. This is not limited in this embodiment of this application.

S504: Split the data page into different data parts.

For example, the data page in the database may include metadata, free space data, tuple data, and special space data. The data page may be split into four different data parts: the metadata, the free space data, the tuple data, and the special space data.

After the different data parts are obtained, the different data parts may be separately compressed according to different compression algorithms. In this way, a data compression rate can be improved according to a compression algorithm related to a data feature.

S505: Compress the metadata according to a compression algorithm 1, to obtain a compressed bitstream of the metadata.

S506: Compress the free space data according to a compression algorithm 2, to obtain a compressed bitstream of the free space data.

S507: Compress the tuple data according to a compression algorithm 3, to obtain a compressed bitstream of the tuple data.

S508: Compress the special space data according to a compression algorithm 4, to obtain a compressed bitstream of the special space data.

It can be learned from S505 and S508 that different compression algorithms may be used on the different data parts in the data page. For example, the compression algorithm 1 may be used on the metadata, the compression algorithm 2 may be used on the free space data, the compression algorithm 3 may be used on the tuple data, and the compression algorithm 4 may be used on the special space data.

The compression algorithm 1, the compression algorithm 2, the compression algorithm 3, and the compression algorithm 4 are not all the same.

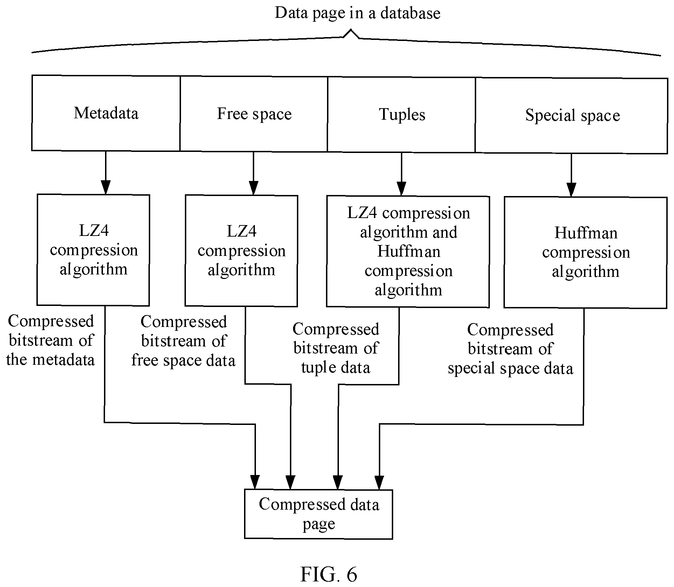

FIG. 6 shows an example of a diagram of different compression algorithms.

As shown in FIG. 6, the compression algorithm 1 may be an LZ4 compression algorithm, and the LZ4 compression algorithm may be used on the metadata, to obtain the compressed bitstream of the metadata; the compression algorithm 2 may also be the LZ4 compression algorithm, and the LZ4 compression algorithm may be used on the free space data, obtain the compressed bitstream of the free space data; the compression algorithm 3 may be the LZ4 compression algorithm and a Huffman compression algorithm, and the LZ4 compression algorithm and the Huffman compression algorithm may be used on the tuple data, to obtain the compressed bitstream of the tuple data; and the compression algorithm 4 may be the Huffman compression algorithm, and the Huffman compression algorithm may be used on the special space data, to obtain the compressed bitstream of the special space data.

It should be noted that the compression algorithm 1, the compression algorithm 2, the compression algorithm 3, and the compression algorithm 4 shown in FIG. 6 are merely used to explain this application. In another embodiment, the compression algorithm 1, the compression algorithm 2, the compression algorithm 3, and the compression algorithm 4 may alternatively be other compression algorithms. This is not limited in embodiments of this application.

Optionally, it is mentioned in the embodiment in FIG. 1 that a data page includes a plurality of pieces of tuple data, metadata of the data page records a plurality of categories of information about each piece of tuple data, different categories of information included in the metadata may be separately classified, and then different categories of information that are classified together are separately compressed. In this way, information of a same category in the metadata is compressed together, so that a compression rate of the metadata can be improved.

For example, the metadata of the data page records len information, offset information, and flag information of each piece of tuple data. Before the metadata is compressed, all len information included in the metadata may be grouped together, all offset information included in the metadata may be grouped together, and all flag information included in the metadata may be grouped together. Then, all the len information, all the offset information, and all the flag information in the metadata are separately compressed to obtain the compressed bitstream of the metadata. In this way, information of a same category in the metadata is compressed together, so that a compression rate of the metadata can be improved.

Optionally, it is mentioned in S503 that the tuple data is a main component of the data page. Therefore, improving a compression rate of the data page in the database is mainly improving a compression rate of the tuple data on the data page.

The following describes how to compress the tuple data.

As shown in FIG. 7, a data page includes a plurality of pieces of tuple data, for example, includes 11 pieces of tuple data in total, the 11 pieces of tuple data are a tuple 1, a tuple 2, a tuple 3, a tuple 4, a tuple 5, a tuple 6, a tuple 7, a tuple 8, a tuple 9, a tuple 10, and a tuple 11, and each tuple stores data.

For a feature of the data stored in the tuple, data stored in a first half of the plurality of pieces of tuple data changes regularly, and data stored in a second half of the plurality of pieces of tuple data is generally irregular. Therefore, the tuple data needs to be split into two parts: tuple data that changes regularly and tuple data that changes irregularly. After the tuple data is split into two parts, a first part of the tuple data that changes regularly is compressed together, and the other part of the tuple data that changes irregularly is compressed together. In this way, a compression rate of the tuple data can be improved.

First, the tuple data on the data page needs to be split into two parts. A first part of the data is tuple data that changes regularly, and a second part of the tuple data is tuple data that changes irregularly.

As shown in FIG. 8, the first part of the tuple data includes m bytes, and the second part of the tuple data includes n bytes.

Optionally, m is an integer multiple of 8. Because a processor reads data by 8 bytes, m may be adapted to a bit width of the data read by the processor. In another embodiment, m may alternatively be another value. This is not limited in embodiments of this application.

Because the data page includes the plurality of pieces of tuple data, a location of an (m-1)^{th} byte may be determined based on first several pieces of tuple data. It may be considered that tuple data before the location of the (m-1)^{th} byte in the last several pieces of tuple data changes regularly. In this way, a data processing amount can be reduced.

For example, the first three pieces of tuple data may be used for determining.

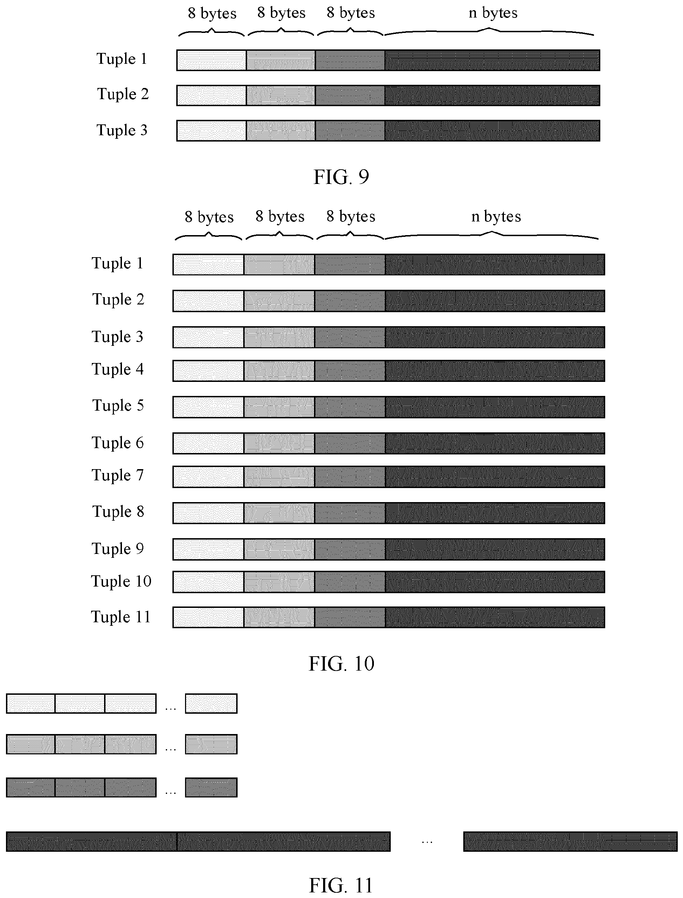

As shown in FIG. 9, 8 bytes are sequentially read from left to right in the tuple 1, the tuple 2, and the tuple 3. For example, for a 1^{st} byte to a 7^{th} byte: a 1^{st} byte in the tuple 1, a 1^{st} byte in the tuple 2, and a 1^{st} byte in the tuple 3 change regularly, for example, are an arithmetic progression or a geometric progression. A 2^{nd} byte in the tuple 1, a 2^{nd} byte in the tuple 2, and a 2^{nd} byte in the tuple 3 also change regularly, for example, are an arithmetic progression or a geometric progression. The rest may be deduced by analogy. An 8^{th} byte in the tuple 1, an 8^{th} byte in the tuple 2, and an 8^{th} byte in the tuple 3 also change regularly, for example, are an arithmetic progression or a geometric progression. In this case, it may be considered that the 1^{st} byte to the 8^{th} byte are data that changes regularly. Therefore, it may be considered that the 1^{st} byte to the 8^{th} byte in the tuple 1 to the tuple 11 are data that changes regularly.

Then, 8 bytes continue to be read rightward in the tuple 1, the tuple 2, and the tuple 3. For example, for a 9^{th} byte to a 16^{th} byte, a 9^{th} byte in the tuple 1, a 9^{th} byte in the tuple 2, and a 9^{th} byte in the tuple 3 change regularly, for example, are an arithmetic progression or a geometric progression. A 10^{th} byte in the tuple 1, a 10^{th} byte in the tuple 2, and a 10^{th} byte in the tuple 3 also change regularly, for example, are an arithmetic progression or a geometric progression. The rest may be deduced by analogy. A 16^{th} byte in the tuple 1, a 16^{th} byte in the tuple 2, and a 16^{th} byte in the tuple 3 also change regularly, for example, are an arithmetic progression or a geometric progression. In this case, it may be considered that the 9^{th} byte to the 16^{th} byte are data that changes regularly. Therefore, it may be considered that the 9^{th} byte to the 16^{th} byte in the tuple 1 to the tuple 11 are data that changes regularly.

A maximum value of m is found in the foregoing manner. For example, m is 24. Any one of a 25^{th} byte to a 32^{nd} byte in the tuple 1, the tuple 2, and the tuple 3 does not change regularly. For example, a 25^{th} byte in the tuple 1, a 25^{th} byte in the tuple 2, and a 25^{th} byte in the tuple 3 do not change regularly. If no regular change is presented, traversing is stopped, and it is determined that the value of m is 24.

After it is determined that the value of m is 24, the first part of the tuple data includes 24 bytes. The second part of the tuple data includes n bytes, and a value of n is related to a length of the tuple data.

According to the foregoing manner, the tuple 1 to the tuple 11 may be split into two parts of tuple data.

As shown in FIG. 10, the first part of the tuple data includes data of a 1^{st} byte to a 24^{th} byte, and the second part of the tuple data includes data of an (m+1)^{th} byte to a (24+n)^{th} byte.

After the two parts of the tuple data are obtained, and before the two parts of the tuple data are compressed, data merging may be performed on the first part of the tuple data, that is, data that changes regularly is placed in a same row, to improve a compression rate of the first part of the tuple data.

FIG. 11 shows a diagram of a manner of performing data merging on the first part of the tuple data.

As shown in FIG. 11, a 1^{st} byte to an 8^{th} byte in the tuple 2 are concatenated after an 8^{th} byte in the tuple 1, and a 1^{st} byte to an 8^{th} byte in the tuple 3 are concatenated after the 8^{th} byte in the tuple 2. The rest may be deduced by analogy until a 1^{st} byte to an 8^{th} byte in the tuple 11 are concatenated after an 8^{th} byte in the tuple 10.

A 9^{th} byte to a 16^{th} byte in the tuple 1 are placed in another row, and a 9^{th} byte to a 16^{th} byte in the tuple 2 are concatenated after the 16^{th} byte in the tuple 1. A 9^{th} byte to a 16^{th} byte in the tuple 3 are concatenated after the 16^{th} byte in the tuple 2. The rest may be deduced by analogy until a 9^{th} byte to a 16^{th} byte in the tuple 11 are concatenated after a 16^{th} byte in the tuple 10.

A 17^{th} byte to a 24^{th} byte in the tuple 1 are placed in another row, and a 17^{th} byte to a 24^{th} byte in the tuple 2 are concatenated after the 24^{th} byte in the tuple 1. A 17^{th} byte to a 24^{th} byte in the tuple 3 are concatenated after the 24^{th} byte in the tuple 2. The rest may be deduced by analogy until a 17^{th} byte to a 24^{th} byte in the tuple 11 are concatenated after a 24^{th} byte in the tuple 10.

A 25^{th} byte to a (24+n)^{th} byte in the tuple 1 are placed in another row, and a 25^{th} byte to a (24+n)^{th} byte in the tuple 2 are concatenated after the (24+n)^{th} byte in the tuple 1. A 25^{th} byte to a (24+n)^{th} byte in the tuple 3 are concatenated after the (24+n)^{th} byte in the tuple 2. The rest may be deduced by analogy until a 25^{th} byte to a (24+n)^{th} byte in the tuple 11 are concatenated after a (24+n)^{th} byte in the tuple 10.

In this way, four rows of data are obtained, and the four rows of data shown in FIG. 11 are separately compressed. Compared with a compression manner of the tuple data shown in FIG. 7, this manner greatly improves a compression rate.

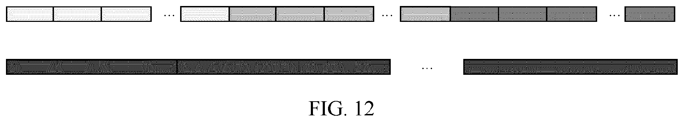

FIG. 12 shows a diagram of another manner of performing data merging on the first part of the tuple data.

As shown in FIG. 12, a 1^{st} byte to an 8^{th} byte in the tuple 2 are concatenated after an 8^{th} byte in the tuple 1, and a 1^{st} byte to an 8^{th} byte in the tuple 3 are concatenated after the 8^{th} byte in the tuple 2. The rest may be deduced by analogy until a 1^{st} byte to an 8^{th} byte in the tuple 11 are concatenated after an 8^{th} byte in the tuple 10.

A 9^{th} byte to a 16^{th} byte in the tuple 1 are concatenated after the 8^{th} byte in the tuple 11. A 9^{th} byte to a 16^{th} byte in the tuple 2 are concatenated after the 16^{th} byte in the tuple 1. A 9^{th} byte to a 16^{th} byte in the tuple 3 are concatenated after the 16^{th} byte in the tuple 2. The rest may be deduced by analogy until a 9^{th} byte to a 16^{th} byte in the tuple 11 are concatenated after a 16^{th} byte in the tuple 10.

A 17^{th} byte to a 24^{th} byte in the tuple 1 are concatenated after the 16^{th} byte in the tuple 11. A 17^{th} byte to a 24^{th} byte in the tuple 2 are concatenated after the 24^{th} byte in the tuple 1. A 17^{th} byte to a 24^{th} byte in the tuple 3 are concatenated after the 24^{th} byte in the tuple 2. The rest may be deduced by analogy until a 17^{th} byte to a 24^{th} byte in the tuple 11 are concatenated after a 24^{th} byte in the tuple 10.

A 25^{th} byte to a (24+n)^{th} byte in the tuple 1 are placed in another row, and a 25^{th} byte to a (24+n)^{th} byte in the tuple 2 are concatenated after the (24+n)^{th} byte in the tuple 1. A 25^{th} byte to a (24+n)^{th} byte in the tuple 3 are concatenated after the (24+n)^{th} byte in the tuple 2. The rest may be deduced by analogy until a 25^{th} byte to a (24+n)^{th} byte in the tuple 11 are concatenated after a (24+n)^{th} byte in the tuple 10.

In this way, two rows of data are obtained, and the two rows of data shown in FIG. 12 are separately compressed. Compared with a compression manner of the tuple data shown in FIG. 7, this manner greatly improves a compression rate.

It should be noted that FIG. 11 and FIG. 12 merely show examples of two manners of performing data merging on the first part of the tuple data. In another embodiment, data merging may alternatively be performed on the first part of the tuple data in another manner. This is not limited in embodiments of this application.

S509: Merge compressed bitstreams of the different data parts, to obtain a compressed data page.

After the compressed bitstream of the metadata, the compressed bitstream of the free space data, the compressed bitstream of the tuple data, and the compressed bitstream of the special space data are obtained, the compressed bitstream of the metadata, the compressed bitstream of the free space data, the compressed bitstream of the tuple data, and the compressed bitstream of the special space data may be merged to obtain the compressed data page.

After the compressed data page is obtained, the compressed data page may be stored in a storage unit. When a size of the compressed data page is less than a size of the storage unit in the storage, one storage unit may store a plurality of compressed data pages. This avoids a waste of storage space in the storage unit.

For example, the compressed data page may include a compressed data page 1 and a compressed data page 2. One storage unit may store all data of the compressed data page 1 and all data of the compressed data page 2, one storage unit may store all data of the compressed data page 1 and partial data of the compressed data page 2, or one storage unit may store partial data of the compressed data page 1 and all data of the compressed data page 2. Specifically, when a sum of a size of the compressed data page 1 and a size of the compressed data page 2 is equal to a size of one storage unit, the one storage unit may store all the data of the compressed data page 1 and all the data of the compressed data page 2. When the size of the compressed data page 1 is less than the size of the one storage unit, but the sum of the size of the compressed data page 1 and the size of the compressed data page 2 is greater than the size of the one storage unit, the one storage unit may store all the data of the compressed data page 1 and partial data of the compressed data page 2.

FIG. 13 shows a diagram of storing a compressed data page in a storage unit.

As shown in FIG. 13, after data in a memory is stored in a database, and before the data in the database is stored in a storage, the data in the database is first compressed, to obtain compressed data. For example, in FIG. 3, a data page 1, a data page 2, a data page 3, a data page 4, and a data page 5 are compressed respectively, to obtain a compressed data page 1, a compressed data page 2, a compressed data page 3, a compressed data page 4, and a compressed data page 5. A size of the compressed data page 1 is 6 KB, and compared with that before compression, the size of the data page 1 is reduced by 2 KB. A size of the compressed data page 2 is 2 KB, and compared with that before compression, the size of the data page 2 is reduced by 6 KB. A size of the compressed data page 3 is 3 KB, and compared with that before compression, the size of the data page 3 is reduced by 5 KB. A size of the compressed data page 4 is 5 KB, and compared with that before compression, the size of the data page 4 is reduced by 3 KB. A size of the compressed data page 5 is 4 KB, and compared with that before compression, the size of the data page 5 is reduced by 4 KB.

After a data page is compressed, if the compressed data page is less than 4 KB, after the compressed data page is stored in a storage unit in the storage, remaining storage space in the storage unit may further store another compressed data page. In this way, all storage space in each storage unit can be fully utilized, and a waste of storage space is avoided.

As shown in FIG. 13, storage space of a storage unit 1 is 4 KB, and the compressed data page 1 is 6 KB. In this case, the storage unit 1 may be entirely used to store partial data of the compressed data page 1. For example, the storage unit 1 may be entirely used to store 4 KB of data in the compressed data page 1. The remaining 2 KB of data in the compressed data page 1 may be stored in a storage unit 2.

Storage space of the storage unit 2 is 4 KB, and the storage unit 1 may be partially used to store the remaining 2 KB of data in the compressed data page 1. The storage unit 2 has 2 KB of remaining storage space. The compressed data page 2 is 2 KB, and the remaining storage space in the storage unit 2 may be entirely used to store the compressed data page 2.

Storage space of a storage unit 3 is 4 KB, and the compressed data page 3 is 3 KB. In this case, the storage unit 3 may be partially used to store data in the compressed data page 3. After the storage unit 3 stores all the data in the compressed data page 3, the storage unit 3 still has 1 KB of remaining storage space. The remaining storage space in the storage unit 3 may be entirely used to store 1 KB of data in the compressed data page 4.

Storage space of a storage unit 4 is 4 KB, and the compressed data page 4 still has 4 KB of data. In this case, the storage unit 4 may be entirely used to store the remaining 4 KB of data in the compressed data page 4.

Storage space of a storage unit 5 is 4 KB, and the compressed data page 5 includes 4 KB of data in total. In this case, the storage unit 5 may be entirely used to store the 4 KB of data in the compressed data page 5.

It can be seen from FIG. 13 that each storage unit in the storage is fully utilized, and no storage space is wasted. It can be learned from FIG. 13 that, for a same compressed data page, a solution in which different compressed data units are stored in one storage unit occupies two fewer storage units compared with a solution that is shown in FIG. 3 and in which one storage unit can store only one compressed data page, thereby improving utilization of storage space of the storage.

**Table 1**

| Identifier of a compressed data page | Location of a compressed data page in an extent | Location of an extent in a storage |
|---|---|---|
| Compressed data page 1 | Locations of a 1^{st} KB to a 6^{th} KB in a first extent | The first extent is located at locations of the 1^{st} KB to the 20^{th} KB in the storage |
| Compressed data page 2 | Locations of a 7^{th} KB and an 8^{th} KB in a first extent | |
| Compressed data page 3 | Locations of a 9^{th} KB to an 11^{th} KB in a first extent | |
| Compressed data page 4 | Locations of a 12^{th} KB to a 16^{th} KB in a first extent | |
| Compressed data page 5 | Locations of a 17^{th} KB to a 20^{th} KB in a first extent | |

Table 1 shows detailed content of PCA information stored in a storage unit 6. Table 1 shows a correspondence between each compressed data page and an extent.

An identifier of a data page may be any one or more of the following: an object identifier ID, a table space ID, a database ID, and the like.

Optionally, in some embodiments, the PCA information may not record the location of the extent in the storage. This is not limited in embodiments of this application.

Optionally, in some embodiments, page compressed data (page compressed data, PCD) may alternatively be stored in the storage, and PCD information records a page of a chunk. The chunk may also be referred to as a compressed chunk.

As shown in Table 1, the compressed data page 1 is stored in the first extent, the compressed data page 1 is located at the locations of the 1^{st} KB to the 6^{th} KB in the first extent, and the first extent is stored at the locations of the 1^{st} KB to the 20^{th} KB in the storage.

The compressed data page 2 is stored in the first extent, the compressed data page 2 is located at the locations of the 7^{th} KB and the 8^{th} KB in the first extent, and the first extent is stored at the locations of the 1^{st} KB to the 20^{th} KB in the storage.

The compressed data page 3 is stored in the first extent, the compressed data page 3 is located at the locations of the 9^{th} KB to the 11^{th} KB in the first extent, and the first extent is stored at the locations of the 1^{st} KB to the 20^{th} KB in the storage.

The compressed data page 4 is stored in the first extent, the compressed data page 4 is located at the locations of the 12^{th} KB to the 16^{th} KB in the first extent, and the first extent is stored at the locations of the 1^{st} KB to the 20^{th} KB in the storage.

The compressed data page 5 is stored in the first extent, the compressed data page 5 is located at the locations of the 17^{th} KB to the 20^{th} KB in the first extent, and the first extent is stored at the locations of the 1^{st} KB to the 20^{th} KB in the storage.

Based on the PCA information shown in Table 1, when a compressed data page stored in a storage unit of the storage needs to be managed, a correspondence between the compressed data page that needs to be managed and an extent may be first found from the PCA information recorded in the storage unit of the storage. After the extent in which the compressed data page that needs to be managed is located is determined, a storage location of the extent in the storage is obtained based on an identifier of the extent. Then, all data of the compressed data page that needs to be managed is determined based on a storage location that is recorded in the PCA information and that is of the compressed data page that needs to be managed in the extent. Then, all the data of the obtained compressed data page is decompressed, to obtain a data page that needs to be managed.

For example, the compressed data page 1 needs to be managed. An extent (for example, the first extent) in which the compressed data page 1 is located may be first found from the PCA information recorded in the storage unit of the storage. Then, that the first extent is located at the locations of the 1^{st} KB to a 21^{st} KB in the storage is obtained from the PCA information. It can be learned that five compressed data pages are stored at the locations of the 1^{st} KB to the 21^{st} KB in the storage. To determine which part stores the compressed data page 1, that data stored at the locations of the 1^{st} KB to the 6^{th} KB in the first extent is data of the compressed data page 1 may be determined based on content that is recorded in the PCA information and that shows that the compressed data page 1 is located at the locations of the 1^{st} KB to the 6^{th} KB in the first extent.

It should be noted that a compressed data page that is not in the database, for example, the compressed to-be-stored data in the embodiment in FIG. 5, may also be stored in the storage unit in the storage according to the method in FIG. 13. For details, refer to descriptions in the embodiment in FIG. 13. Details are not described herein again in this embodiment of this application.

Optionally, to quickly allocate storage space and facilitate management of a data page stored in a storage unit, in this application, a compressed data page may be split into one or more chunks, and then the chunks are stored in the storage unit. A chunk has a fixed size, and the storage space of the storage unit is an integer multiple of the chunk. In addition, a correspondence between storage locations of the chunks in the storage unit and the compressed data page is established. This facilitates allocation of the storage space of the storage unit and subsequent management of different compressed data pages stored in a same storage unit.

For example, the size of the chunk may be 2 KB.

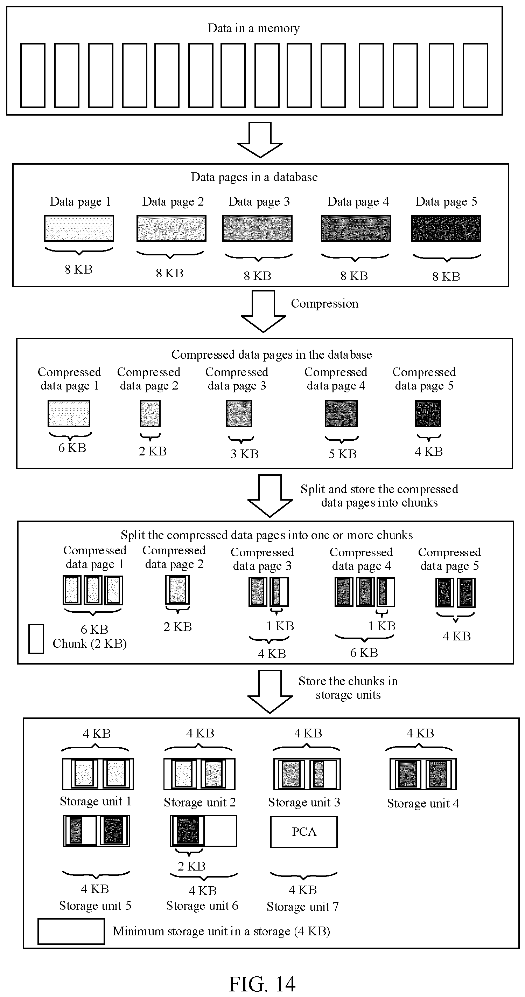

FIG. 14 shows another diagram of storing a compressed data page in a storage unit.

As shown in FIG. 14, after the compressed data page is obtained, and before the compressed data page is stored in a storage, the data page is first split into one or more chunks.

A size of a chunk is 2 KB.

A compressed data page 1 is 6 KB. Therefore, the compressed data page 1 needs to be split into three chunks, and the three chunks may be a chunk 1, a chunk 2, and a chunk 3.

A compressed data page 2 is 2 KB. Therefore, the compressed data page 1 needs to be split into one chunk, and the chunk may be a chunk 4.

A compressed data page 3 is 3 KB. Therefore, the compressed data page 3 needs to be split into two chunks, and the two chunks may be a chunk 5 and a chunk 6. The chunk 6 stores only 1 KB of data.

A compressed data page 4 is 5 KB. Therefore, the compressed data page 4 needs to be split into three chunks, and the three chunks may be a chunk 7, a chunk 8, and a chunk 9. The chunk 9 stores only 1 KB of data.

A compressed data page 5 is 4 KB. Therefore, the compressed data page 5 needs to be split into two chunks, and the two chunks may be a chunk 10 and a chunk 11.

After the compressed data page is split into the one or more chunks, the plurality of chunks are stored in a storage unit in the storage.

A size of the storage unit in the storage is an integer multiple of the size of the chunk.

As shown in FIG. 14, a storage unit 1 may store the chunk 1 and the chunk 2.

A storage unit 2 may store the chunk 3 and the chunk 4.

A storage unit 3 may store the chunk 5 and the chunk 6.

A storage unit 4 may store the chunk 7 and the chunk 8.

A storage unit 5 may store the chunk 9 and the chunk 10.

A storage unit 6 may store the chunk 11.

It can be seen from FIG. 14 that each storage unit in the storage is fully utilized, and no storage space is wasted. It can be learned from FIG. 14 that, for a same compressed data page, a solution in which different compressed data units are stored in one storage unit occupies one fewer storage unit compared with a solution that is shown in FIG. 3 and in which one storage unit can store only one compressed data page, thereby improving utilization of storage space of the storage.

As shown in FIG. 14, a storage unit 7 further stores page compressed address (Page Compressed Address, PCA) information.

The PCA information records a correspondence between a compressed data page and a chunk.

**Table 2**

| Identifier of a compressed data page | Identifier of a chunk corresponding to a compressed data page | Location of a chunk in a storage unit |
|---|---|---|
| Compressed data page 1 | Chunk 1 | 1^{st} KB and 2^{nd} KB in a storage unit 1 |
| Compressed data page 1 | Chunk 2 | 3^{rd} KB and 4^{th} KB in a storage unit 1 |
| Compressed data page 1 | Chunk 3 | 1^{st} KB and 2^{nd} KB in a storage unit 2 |
| Compressed data page 2 | Chunk 4 | 3^{rd} KB and 4^{th} KB in a storage unit 2 |
| Compressed data page 3 | Chunk 5 | 1^{st} KB and 2^{nd} KB in a storage unit 3 |
| Compressed data page 3 | Chunk 6 | 3^{rd} KB and 4^{th} KB in a storage unit 3 |
| Compressed data page 4 | Chunk 7 | 1^{st} KB and 2^{nd} KB in a storage unit 4 |
| Compressed data page 4 | Chunk 8 | 3^{rd} KB and 4^{th} KB in a storage unit 4 |
| Compressed data page 4 | Chunk 9 | 1^{st} KB and 2^{nd} KB in a storage unit 5 |
| Compressed data page 5 | Chunk 10 | 3^{rd} KB and 4^{th} KB in a storage unit 5 |
| Compressed data page 5 | Chunk 11 | 1^{st} KB and 2^{nd} KB in a storage unit 6 |

Table 2 shows detailed content of the PCA information stored in the storage unit 7. Table 1 shows a storage location of each chunk in a storage unit in the storage.

As shown in Table 1, identifiers of chunks corresponding to the compressed data page 1 are the chunk 1, the chunk 2, and the chunk 3, a storage location of the chunk 1 is the 1^{st} KB and the 2^{nd} KB in the storage unit 1, a storage location of the chunk 2 is the 3^{rd} KB and the 4^{th} KB in the storage unit 1, and a storage location of the chunk 3 is the 1^{st} KB and the 2^{nd} KB in the storage unit 2; an identifier of a chunk corresponding to the compressed data page 2 is the chunk 4, and a storage location of the chunk 4 is the 3^{rd} KB and the 4^{th} KB in the storage unit 2; identifiers of chunks corresponding to the compressed data page 3 are the chunk 5 and the chunk 6, a storage location of the chunk 5 is the 1^{st} KB and the 2^{nd} KB in the storage unit 3, and a storage location of the chunk 6 is the 3^{rd} KB and the 4 ^{th} KB in the storage unit 3; identifiers of chunks corresponding to the compressed data page 4 are the chunk 7, the chunk 8, and the chunk 9, a storage location of the chunk 7 is the 1^{st} KB and the 2^{nd} KB in the storage unit 4, a storage location of the chunk 8 is the 3^{rd} KB and the 4^{th} KB in the storage unit 4, and a storage location of the chunk 9 is the 1^{st} KB and the 2^{nd} KB in the storage unit 5; and identifiers of chunks corresponding to the compressed data page 5 are the chunk 10 and the chunk 11, a storage location of the chunk 10 is the 3^{rd} KB and the 4^{th} KB in the storage unit 5, and a storage location of the chunk 11 is the 1^{st} KB and the 2^{nd} KB in the storage unit 6.

Based on the PCA information shown in Table 1, when a compressed data page stored in a storage unit of the storage needs to be managed, a correspondence between the compressed data page that needs to be managed and a chunk may be first found from the PCA information recorded in the storage unit 7. After the chunk in which the compressed data page that needs to be managed is located is determined, the compressed page that needs to be managed is directly obtained based on a storage location of the chunk in which the compressed data page that needs to be managed is located in a storage unit. This reduces time for searching for the compressed data page, and facilitates management of the compressed data page.

For example, the compressed data page 1 needs to be managed. The chunks corresponding to the compressed data page 1 may be first found from the PCA information recorded in the storage unit 7. For example, it is determined, from the PCA information, that the chunks corresponding to the compressed data page 1 are the chunk 1, the chunk 2, and the chunk 3. Based on the chunk 1, the chunk 2, and the chunk 3, it may be further determined that the storage location of the chunk 1 is the 1^{st} KB and the 2^{nd} KB in the storage unit 1, the storage location of the chunk 2 is the 3^{rd} KB and the 4^{th} KB in the storage unit 1, and the storage location of the chunk 3 is the 1^{st} KB and the 2^{nd} KB in the storage unit 2. Then, the compressed data page 1 may be directly obtained from storage locations of the 1^{st} KB and the 2^{nd} KB in the storage unit 1, storage locations of the 3^{rd} KB and the 4^{th} KB in the storage unit 1, and storage locations of the 1^{st} KB and the 2^{nd} KB in the storage unit 2.

The embodiment of Table 2 is shown by performing compression and storage in a unit of a single data page in the database. In some embodiments, compression and storage may alternatively be performed in a unit of a plurality of data pages.

Optionally, the database stores a plurality of data pages, and before the data pages in the database are stored in the storage, a specific quantity (for example, 128) of pages in the database may be first combined into one extent. Each extent includes 128 data pages, and each data page has a fixed location in the extent.

For example, before the data pages are compressed, each data page has a fixed size (for example, 8 KB), and each data page has a fixed storage location in the extent.

**Table 3**

| Identifier of a data page | Location of a data page in an extent |
|---|---|
| Data page 1 | Locations of a 1^{st} KB to an 8^{th} KB in a first extent |
| Data page 2 | Locations of a 9^{th} KB to a 16^{th} KB in a first extent |
| Data page 3 | Locations of a 17^{th} KB to a 24^{th} KB in a first extent |
| ... | ... |
| Data page N | Locations of an (8×(N-1)+1)^{th} KB to an (8×N)^{th} KB in a first extent |

Table 3 shows a storage location of a data page in a database in an extent before the data page in the database is compressed. For example, the data page 1 is located at the locations of the 1^{st} KB to the 8^{th} KB in the first extent, the data page 2 is located at the locations of the 9^{th} KB to the 16^{th} KB in the first extent, the data page 3 is located at the locations of the 17^{th} KB to the 24^{th} KB in the first extent, and the data page N is located at the locations of the (8×(N-1)+1)^{th} KB to the (128×N)^{th} KB in the first extent.

It should be noted that the database further includes more other extents. This is not limited in embodiments of this application.

Before the data page in the database is compressed, the data page in the database is stored in a unit of extent. A size of one extent is a quantity of data pages stored in the extent multiplied by a size of each data page. For example, one extent includes 128 data pages, and a size of each data page is 8 KB. In this case, a size of the extent is 128×8 KB, and when the extent is stored in the storage, the extent needs to occupy 128×8 KB storage space. If a size of a storage unit in the storage is 4 KB, the extent needs to occupy 256 storage units.

To save storage space, the data page in the database may be first compressed and then stored in the storage. That is, each extent is compressed and then stored in the storage.

For example, compressing each extent may be understood as compressing each data page in the extent. In this case, after each data page is compressed, a storage location of each compressed data page in the extent changes.

For example, it is assumed that the first extent has five compressed data pages.

**Table 4**

| Identifier of a compressed data page | Location of a compressed data page in an extent |
|---|---|
| Compressed data page 1 | Locations of a 1^{st} KB to a 6^{th} KB in a first extent |
| Compressed data page 2 | Locations of a 7^{th} KB and an 8^{th} KB in a first extent |
| Compressed data page 3 | Locations of a 9^{th} KB to an 11^{th} KB in a first extent |
| Compressed data page 4 | Locations of a 12^{th} KB to a 17^{th} KB in a first extent |
| Compressed data page 5 | Locations of an 18^{th} KB to a 21^{st} KB in a first extent |

For example, a size of a chunk is 2 KB.

Table 4 shows a storage location of a data page in a database in an extent after the data page is compressed. For example, the data page 1 is compressed to obtain the compressed data page 1, and a size of the compressed data page 1 is 6 KB; then, the compressed data page 1 is split into a plurality of chunks, and the compressed data page 1 may be split into the chunk 1, the chunk 2, and the chunk 3; and the compressed data page 1 is located at the locations of the 1^{st} KB to the 6^{th} KB in the first extent. The data page 2 is compressed to obtain the compressed data page 2, and a size of the compressed data page 2 is 2 KB; then, the compressed data page 2 is split into a plurality of chunks, and the compressed data page 2 may be split into the chunk 4; and the compressed data page 2 is located at the locations of the 7^{th} KB and the 8^{th} KB in the first extent. The data page 3 is compressed to obtain the compressed data page 3, and a size of the compressed data page 3 is 3 KB; then, the compressed data page 3 is split into a plurality of chunks, and the compressed data page 3 may be split into the chunk 5 and the chunk 6; and the compressed data page 3 is located at the locations of the 9^{th} KB to the 11^{th} KB in the first extent. The data page 4 is compressed to obtain the compressed data page 4, and a size of the compressed data page 4 is 5 KB; then, the compressed data page 4 is split into a plurality of chunks, and the compressed data page 4 may be split into the chunk 7, the chunk 8, and the chunk 9; and the compressed data page 4 is located at the locations of the 12^{th} KB to the 17^{th} KB in the first extent. The data page 5 is compressed to obtain the compressed data page 5, and a size of the compressed data page 5 is 4 KB; then, the compressed data page 5 is split into a plurality of chunks, and the compressed data page 4 may be split into the chunk 10 and the chunk 11; and the compressed data page 5 is located at the locations of the 18^{th} KB to the 21^{st} KB in the first extent.

After one or more compressed extents are obtained, a location of each compressed data page in each compressed extent in the compressed extent and a correspondence between each compressed data page in each compressed extent and a plurality of chunks need to be recorded. In addition, the location of each compressed data page in each compressed extent in the compressed extent and the correspondence between each compressed data page in each compressed extent and the plurality of chunks are stored in the storage, to facilitate subsequent management of the compressed data page.

**Table 5**

| Identifier of a compressed data page | Identifier of a chunk corresponding to a compressed data page | Location of a compressed data page in an extent | Storage location of an extent in a storage |
|---|---|---|---|
| Compressed data page 1 | Chunk 1, chunk 2, and chunk 3 | Locations of a 1^{st} KB to a 6^{th} KB in a first extent | The first extent is located at locations of the 1^{st} KB to the 21^{st} KB in the storage |
| Compressed data page 2 | Chunk 4 | Locations of a 7^{th} KB and an 8^{th} KB in a first extent | |
| Compressed data page 3 | Chunk 5 and chunk 6 | Locations of a 9^{th} KB to an 11^{th} KB in a first extent | |
| Compressed data page 4 | Chunk 7, chunk 8, and chunk 9 | Locations of a 12^{th} KB to a 17^{th} KB in a first extent | |
| Compressed data page 5 | Chunk 10 and chunk 11 | Locations of an 18^{th} KB to a 21^{st} KB in a first extent | |

Table 5 shows another type of information recorded in the PCA. The PCA records a location of a compressed data page in a corresponding extent and a storage location of each extent in the storage.

Optionally, in some embodiments, the PCA information may not record the storage location of each extent in the storage. This is not limited in embodiments of this application.

As shown in Table 4, identifiers of chunks corresponding to the compressed data page 1 are the chunk 1, the chunk 2, and the chunk 3, the compressed data page 1 is stored in the first extent, the compressed data page 1 is located at the locations of the 1^{st} KB to the 6^{th} KB in the first extent, and the first extent is stored at the locations of the 1^{st} KB to the 21^{st} KB in the storage.

An identifier of a chunk corresponding to the compressed data page 2 is the chunk 4, the compressed data page 2 is stored in the first extent, the compressed data page 2 is located at the locations of the 7^{th} KB and the 8^{th} KB in the first extent, and the first extent is stored at the locations of the 1^{st} KB to the 21^{st} KB in the storage.

Identifiers of chunks corresponding to the compressed data page 3 are the chunk 5 and the chunk 6, the compressed data page 3 is stored in the first extent, the compressed data page 3 is located at the locations of the 9^{th} KB to the 11^{th} KB in the first extent, and the first extent is stored at the locations of the 1^{st} KB to the 21^{st} KB in the storage.

Identifiers of chunks corresponding to the compressed data page 4 are the chunk 7, the chunk 8, and the chunk 9, the compressed data page 4 is stored in the first extent, the compressed data page 4 is located at the locations of the 12^{th} KB to the 17^{th} KB in the first extent, and the first extent is stored at the locations of the 1^{st} KB to the 21^{st} KB in the storage.

Identifiers of chunks corresponding to the compressed data page 5 are the chunk 10 and the chunk 11, the compressed data page 5 is stored in the first extent, the compressed data page 5 is located at the locations of the 18^{th} KB to the 21^{st} KB in the first extent, and the first extent is stored at the locations of the 1^{st} KB to the 21^{st} KB in the storage.

Based on the PCA information shown in Table 5, when a compressed data page stored in a storage unit of the storage needs to be managed, a correspondence between the compressed data page that needs to be managed and a chunk and a correspondence between the compressed data page and an extent may be first found from the PCA information recorded in the storage unit of the storage. After the extent in which the compressed data page that needs to be managed is located is determined, a storage location of the extent in the storage is obtained based on an identifier of the extent. Then, storage locations, in the extent, of one or more chunks corresponding to the compressed data page that needs to be managed are obtained based on the correspondence between the compressed data page and the chunks, to determine all data of the compressed data page that needs to be managed. Then, all the data of the obtained compressed data page is decompressed, to obtain a data page that needs to be managed.

For example, the compressed data page 1 needs to be managed. An extent (for example, the first extent) in which the compressed data page 1 is located may be first found from the PCA information recorded in the storage unit of the storage. Then, it is determined, from the PCA information, that chunks corresponding to the compressed data page 1 are the chunk 1, the chunk 2, and the chunk 3. Then, that the first extent is located at the locations of the 1^{st} KB to the 21^{st} KB in the storage is obtained from the PCA information. Therefore, it can be learned that five compressed data pages are stored at the locations of the 1^{st} KB to the 21^{st} KB in the storage. To determine which part stores the compressed data page 1, that data stored at the locations of the 1^{st} KB to the 6^{th} KB in the first extent is data of the compressed data page 1 may be determined based on locations that are in the extent and that are of the chunk 1 corresponding to the compressed data page 1, the chunk 2 corresponding to the compressed data page 1, and the chunk 3 corresponding to the compressed data page 1 and that are recorded in the PCA information.

Optionally, if the PCA information does not record a storage location of each extent in the storage, a storage location of the first extent in the storage further needs to be determined based on an identifier of the first extent. For example, it is determined that the first extent is located in the 1^{st} KB to the 21^{st} KB in the storage. Specifically, the storage stores a plurality of extents, and the storage location of the first extent in the storage may be obtained from the storage in a sequential traversal manner. After the storage location of the first extent in the storage is determined, content of all compressed data stored in the first extent may be determined. Then, that the chunks corresponding to the compressed data page 1 are the chunk 1, the chunk 2, and the chunk 3 is found from the PCA information recorded in the storage unit of the storage. To determine which part of the first extent stores the compressed data page 1, that data stored at the locations of the 1^{st} KB to the 6^{th} KB in the first extent is data of the compressed data page 1 may be determined based on locations that are in the extent and that are of the chunk 1 corresponding to the compressed data page 1, the chunk 2 corresponding to the compressed data page 1, and the chunk 3 corresponding to the compressed data page 1 and that are recorded in the PCA information.

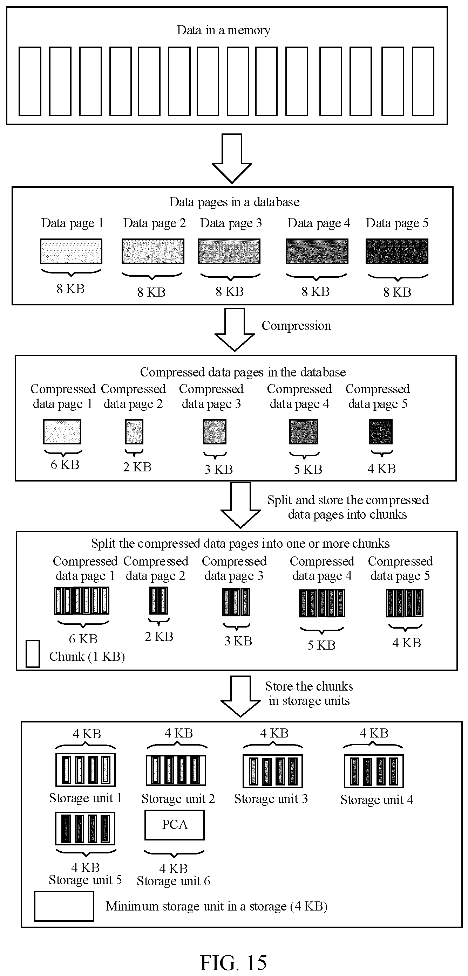

FIG. 15 shows still another diagram of storing a compressed data page in a storage unit.

After the compressed data page is obtained, and before the compressed data page is stored in a storage, the data page is first split and stored in a plurality of chunks.

A size of a chunk is 1 KB.

A difference between the embodiment in FIG. 15 and the embodiment in FIG. 14 lies in that a size of a chunk in FIG. 15 is 1 KB, and a size of a chunk in FIG. 14 is 2 KB.

It can be seen from FIG. 14 that only 1 KB of data is stored in the chunk 6, and remaining 1 KB of storage space in the chunk 6 is not used. As a result, 1 KB of storage space in the storage unit 3 is not used. In FIG. 15, a size of a chunk is 1 KB. In this way, the foregoing problem can be resolved. A smaller size of a chunk indicates higher utilization of a storage unit. The size of the chunk may alternatively be another value, for example, 512 B or 4 KB. The size of the chunk is not limited in embodiments of this application.

As shown in FIG. 15, a compressed data page 1 is 6 KB. Therefore, the compressed data page 1 needs to be split into six chunks, and the three chunks may be a chunk 1, a chunk 2, a chunk 3, a chunk 4, a chunk 5, and a chunk 6.

A compressed data page 2 is 2 KB. Therefore, the compressed data page 1 needs to be split into two chunks, and the two chunks may be a chunk 7 and a chunk 8.

A compressed data page 3 is 3 KB. Therefore, the compressed data page 3 needs to be split into three chunks, and the three chunks may be a chunk 9, a chunk 10, and a chunk 11.

A compressed data page 4 is 5 KB. Therefore, the compressed data page 4 needs to be split into five chunks, and the five chunks may be a chunk 12, a chunk 13, a chunk 14, a chunk 15, and a chunk 16.

A compressed data page 5 is 4 KB. Therefore, the compressed data page 5 needs to be split into four chunks, and the four chunks may be a chunk 17, a chunk 18, a chunk 19, and a chunk 20.

After the compressed data page is split into one or more chunks, the plurality of chunks are stored in a storage unit in the storage.

A size of the storage unit in the storage is an integer multiple of the size of the chunk.

As shown in FIG. 15, a storage unit 1 may store the chunk 1, the chunk 2, the chunk 3, and the chunk 4.

A storage unit 2 may store the chunk 5, the chunk 6, the chunk 7, and the chunk 8.

A storage unit 3 may store the chunk 9, the chunk 10, the chunk 11, and the chunk 12.

A storage unit 4 may store the chunk 13, the chunk 14, the chunk 15, and the chunk 16.

A storage unit 5 may store the chunk 17, the chunk 18, the chunk 19, and the chunk 20.

The data compression storage method shown in the embodiment in FIG. 13 may be understood as storing compressed data pages in serial. For example, there is the compressed data page 1 and the compressed data page 2, the compressed data page 1 is 6 KB, the compressed data page 2 is 3 KB, and storage space of a storage unit is 4 KB. The compressed data page 1 is stored in the storage unit 1 and the storage unit 2, and the storage unit 2 stores only 2 KB of data. Only after the compressed data page 1 is stored, it can be learned that 2 KB of data in the compressed data page 2 may be stored in the remaining 2 KB of storage space in the storage unit 2. In other words, the compressed data page 2 can be stored only after the compressed data page 1 is stored. This is serial storage.

The data compression storage methods shown in the embodiment in FIG. 14 and the embodiment in FIG. 15 may be understood as storing compressed data pages in parallel. For example, there is the compressed data page 1 and the compressed data page 2, the compressed data page 1 is 6 KB, the compressed data page 2 is 3 KB, and storage space of a storage unit is 4 KB. In the embodiment in FIG. 14 and the embodiment in FIG. 15, the compressed data page 1 and the compressed data page 2 are split into chunks. The storage space of the storage unit is an integer multiple of a chunk. For example, one storage unit may store four chunks. Therefore, after the compressed data page is split into the chunks, a specific quantity (for example, four) of chunks may be selected and stored in both the storage unit 1 and the storage unit 2, that is, four chunks may be stored in both the storage unit 1 and the storage unit 2 at the same time. In other words, the compressed data page 1 and the compressed data page 2 may be stored in the storage unit at the same time. This is parallel storage. Compared with serial storage, parallel storage can save time for storing compressed data pages.

It can be seen from FIG. 15 that each storage unit in the storage is fully utilized, and no storage space is wasted. It can be learned from FIG. 15 that, for a same compressed data page, a solution in which different compressed data units are stored in one storage unit occupies two fewer storage units compared with a solution that is shown in FIG. 3 and in which one storage unit can store only one compressed data page, thereby improving utilization of storage space of the storage.

As shown in FIG. 15, a storage unit 6 further stores PCA information.

**Table 6**

| Identifier of a compressed data page | Identifier of a chunk corresponding to a compressed data page | Location of a chunk in a storage unit |
|---|---|---|
| Compressed data page 1 | Chunk 1 | 1^{st} KB in a storage unit 1 |
| Compressed data page 1 | Chunk 2 | 2^{nd} KB in a storage unit 1 |
| Compressed data page 1 | Chunk 3 | 3^{rd} KB in a storage unit 1 |
| Compressed data page 1 | Chunk 4 | 4^{th} KB in a storage unit 1 |
| Compressed data page 1 | Chunk 5 | 1^{st} KB in a storage unit 2 |
| Compressed data page 1 | Chunk 6 | 2^{nd} KB in a storage unit 2 |
| Compressed data page 2 | Chunk 7 | 3^{rd} KB in a storage unit 2 |
| Compressed data page 2 | Chunk 8 | 4^{th} KB in a storage unit 2 |
| Compressed data page 3 | Chunk 9 | 1^{st} KB in a storage unit 3 |
| Compressed data page 3 | Chunk 10 | 2^{nd} KB in a storage unit 3 |
| Compressed data page 3 | Chunk 11 | 3^{rd} KB in a storage unit 3 |
| Compressed data page 4 | Chunk 12 | 4^{th} KB in a storage unit 3 |
| Compressed data page 4 | Chunk 13 | 1^{st} KB in a storage unit 4 |
| Compressed data page 4 | Chunk 14 | 2^{nd} KB in a storage unit 4 |
| Compressed data page 4 | Chunk 15 | 3^{rd} KB in a storage unit 4 |
| Compressed data page 4 | Chunk 16 | 4^{th} KB in a storage unit 4 |
| Compressed data page 5 | Chunk 17 | 1^{st} KB in a storage unit 5 |
| Compressed data page 5 | Chunk 18 | 2^{nd} KB in a storage unit 5 |
| Compressed data page 5 | Chunk 19 | 3^{rd} KB in a storage unit 5 |
| Compressed data page 5 | Chunk 20 | 4^{th} KB in a storage unit 5 |

Table 6 shows detailed content of another type of PCA information stored in the storage unit 6. Table 5 shows a correspondence between each chunk and a storage unit in the storage.

As shown in Table 6, identifiers of chunks corresponding to the compressed data page 1 are the chunk 1, the chunk 2, the chunk 3, the chunk 4, the chunk 5, and the chunk 6, a storage location of the chunk 1 is the 1^{st} KB in the storage unit 1, a storage location of the chunk 2 is the 2^{nd} KB in the storage unit 1, a storage location of the chunk 3 is the 3^{rd} KB in the storage unit 1, a storage location of the chunk 4 is the 4^{th} KB in the storage unit 1, a storage location of the chunk 5 is the 1^{st} KB in the storage unit 2, and a storage location of the chunk 6 is the 2^{nd} KB in the storage unit 2; identifiers of chunks corresponding to the compressed data page 2 are the chunk 7 and the chunk 8, a storage location of the chunk 7 is the 3^{rd} KB in the storage unit 2, and a storage location of the chunk 8 is the 4^{th} KB in the storage unit 2; identifiers of chunks corresponding to the compressed data page 3 are the chunk 9, the chunk 10, and the chunk 11, a storage location of the chunk 9 is the 1^{st} KB in the storage unit 3, a storage location of the chunk 10 is the 2^{nd} KB in the storage unit 3, and a storage location of the chunk 11 is the 3^{rd} KB in the storage unit 3; identifiers of chunks corresponding to the compressed data page 4 are the chunk 12, the chunk 13, the chunk 14, the chunk 15, and the chunk 16, a storage location of the chunk 12 is the 4^{th} KB in the storage unit 3, a storage location of the chunk 13 is the 1^{st} KB in the storage unit 4, a storage location of the chunk 14 is the 2^{nd} KB in the storage unit 4, a storage location of the chunk 15 is the 3^{rd} KB in the storage unit 4, and a storage location of the chunk 16 is the 4^{th} KB in the storage unit 4; and identifiers of chunks corresponding to the compressed data page 5 are the chunk 17, the chunk 18, the chunk 19, and the chunk 20, a storage location of the chunk 17 is the 1^{st} KB in the storage unit 5, a storage location of the chunk 18 is the 2^{nd} KB in the storage unit 5, a storage location of the chunk 19 is the 3^{rd} KB in the storage unit 5, and a storage location of the chunk 20 is the 4^{th} KB in the storage unit 5.

A method for searching for a compressed data page based on Table 6 is similar to a method for searching for a compressed data page based on Table 1. Details are not described herein again in embodiments of this application.

**Table 7**

| Identifier of a compressed data page | Identifier of a chunk corresponding to a compressed data page | Location of a compressed data page in an extent | Storage location of an extent in a storage |
|---|---|---|---|
| Compressed data page 1 | Chunk 1 | Location of a 1^{st} KB in a first extent | The first extent is located at locations of the 1^{st} KB to the 20^{th} KB in the storage |
| Compressed data page 1 | Chunk 2 | Location of a 2^{nd} KB in a first extent | |
| Compressed data page 1 | Chunk 3 | Location of a 3^{rd} KB in a first extent | |
| Compressed data page 1 | Chunk 4 | Location of a 4^{th} KB in a first extent | |
| Compressed data page 1 | Chunk 5 | Location of a 5^{th} KB in a first extent | |
| Compressed data page 1 | Chunk 6 | Location of a 6^{th} KB in a first extent | |
| Compressed data page 2 | Chunk 7 | Location of a 7^{th} KB in a first extent | |
| Compressed data page 2 | Chunk 8 | Location of an 8^{th} KB in a first extent | |
| Compressed data page 3 | Chunk 9 | Location of a 9^{th} KB in a first extent | |
| Compressed data page 3 | Chunk 10 | Location of a 10^{th} KB in a first extent | |
| Compressed data page 3 | Chunk 11 | Location of an 11^{th} KB in a first extent | |
| Compressed data page 4 | Chunk 12 | Location of a 12^{th} KB in a first extent | |
| Compressed data page 4 | Chunk 13 | Location of a 13^{th} KB in a first extent | |
| Compressed data page 4 | Chunk 14 | Location of a 14^{th} KB in a first extent | |
| Compressed data page 4 | Chunk 15 | Location of a 15^{th} KB in a first extent | |
| Compressed data page 4 | Chunk 16 | Location of a 16^{th} KB in a first extent | |
| Compressed data page 5 | Chunk 17 | Location of a 17^{th} KB in a first extent | |
| Compressed data page 5 | Chunk 18 | Location of an 18^{th} KB in a first extent | |
| Compressed data page 5 | Chunk 19 | Location of a 19^{th} KB in a first extent | |
| Compressed data page 5 | Chunk 20 | Location of a 20^{th} KB in a first extent | |

A difference between Table 7 and Table 5 lies in that a size of a chunk in Table 7 is 1 KB, and a size of a chunk in Table 5 is 2 KB.

Table 7 shows another type of information recorded in the PCA. The PCA records a location of a compressed data page in a corresponding extent and a storage location of each extent in the storage.

Optionally, in some embodiments, the PCA information may not record the storage location of each extent in the storage. This is not limited in embodiments of this application.

As shown in Table 7, identifiers of chunks corresponding to the compressed data page 1 are the chunk 1, the chunk 2, the chunk 3, the chunk 4, the chunk 5, and the chunk 6, the compressed data page 1 is stored in the first extent, the compressed data page 1 is located at locations of the 1^{st} KB to the 6^{th} KB in the first extent, and the first extent is stored at the locations of the 1^{st} KB to the 20^{th} KB in the storage.

Identifiers of chunks corresponding to the compressed data page 2 are the chunk 7 and the chunk 8, the compressed data page 2 is stored in the first extent, the compressed data page 2 is located at locations of the 7^{th} KB and the 8^{th} KB in the first extent, and the first extent is stored at the locations of the 1^{st} KB to the 20^{th} KB in the storage.

Identifiers of chunks corresponding to the compressed data page 3 are the chunk 9, the chunk 10, and the chunk 11, the compressed data page 3 is stored in the first extent, the compressed data page 3 is located at locations of the 9^{th} KB to the 11^{th} KB in the first extent, and the first extent is stored at the locations of the 1^{st} KB to the 20^{th} KB in the storage.

Identifiers of chunks corresponding to the compressed data page 4 are the chunk 12, the chunk 13, the chunk 14, the chunk 15, and the chunk 16, the compressed data page 4 is stored in the first extent, the compressed data page 4 is located at locations of the 12^{th} KB to the 16^{th} KB in the first extent, and the first extent is stored at the locations of the 1^{st} KB to the 20^{th} KB in the storage.

Identifiers of chunks corresponding to the compressed data page 5 are the chunk 18, the chunk 19, and the chunk 20, the compressed data page 5 is stored in the first extent, the compressed data page 5 is located at locations of the 19^{th} KB to the 2^{nd} KB in the first extent, and the first extent is stored at the locations of the 1^{st} KB to the 20^{th} KB in the storage.

A method for searching for a compressed data page based on Table 7 is similar to a method for searching for a compressed data page based on Table 5. Details are not described herein again in embodiments of this application.

It should be noted that embodiments of this application are described by using an example of how a data page in a database is stored in a storage. In another embodiment, a data page that is not in the database, for example, other to-be-stored data, may also be stored in a storage unit in the storage according to the embodiments shown in FIG. 13 to FIG. 15. Principles are similar, and details are not described herein again in embodiments of this application.

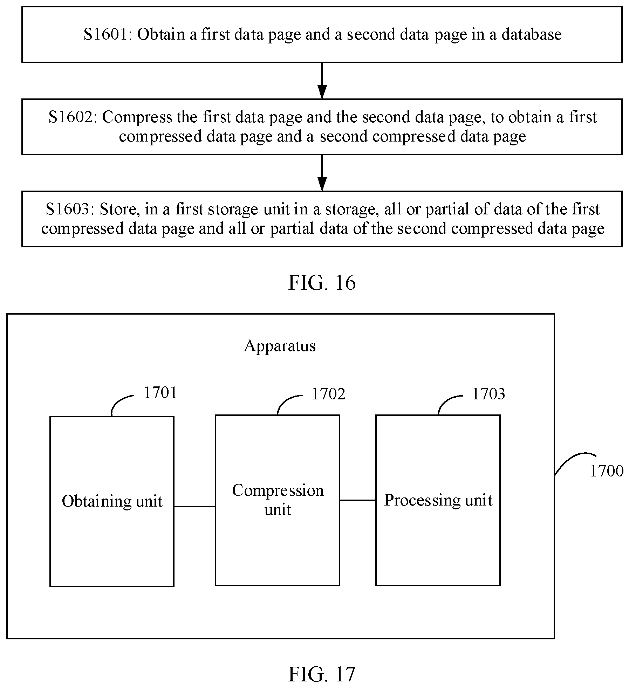

FIG. 16 is a schematic flowchart of a data storage method according to an embodiment of this application.

S1601: Obtain a first data page and a second data page in a database.

S1602: Compress the first data page and the second data page, to obtain a first compressed data page and a second compressed data page.

In a possible implementation, compressing the first data page to obtain the first compressed data page specifically includes: splitting the first data page into a first data part and a second data part; compressing the first data part according to a first compression algorithm to obtain a first compressed data stream; compressing the second data part according to a second compression algorithm, to obtain a second compressed data stream; and merging the first compressed data stream and the second compressed data stream, to obtain the first compressed data page, where the first compression algorithm is different from the first compressed data stream.

It should be noted that the first data page may be further split into more data parts. For example, the split data parts further include a third data part and a fourth data part.

Different data on a data page is compressed according to different compression algorithms, so that a compression rate of the data page can be improved.

For details, refer to descriptions in the embodiments in FIG. 5 and FIG. 6. Details are not described herein again in this embodiment of this application.

In a possible implementation, compressing tuple data according to the second compression algorithm to obtain the second compressed data stream specifically includes: splitting the tuple data into a first part of the tuple data and a second part of the tuple data, where the first part of the tuple data includes the first m bytes of each piece of tuple data, and the second part of the data includes the last n bytes of each piece of tuple data; compressing the first part of the tuple data according to an LZ4 compression algorithm, to obtain a first part of compressed tuple data; compressing the second part of the tuple data according to a Huffman compression algorithm, to obtain a second part of the compressed tuple data; and merging the first part of the compressed tuple data and the second part of the compressed tuple data, to obtain the second compressed data stream.

The tuple data may be further split into different data, and different data is compressed according to different compression algorithms, so that a compression rate of the tuple data can be improved.

For details, refer to descriptions in the embodiments in FIG. 7 to FIG. 12. Details are not described herein again in this embodiment of this application.

In a possible implementation, splitting the tuple data into the first part of the tuple data and the second part of the tuple data specifically includes: when the tuple data on the first compressed data page is greater than a first value, splitting the tuple data into the first part of the tuple data and the second part of the tuple data.

When the tuple data on the first compressed data page is less than the first value, for example, when the tuple data has only one row, it is unnecessary to split the tuple data, and a compression rate of the tuple data after splitting is similar to a compression rate of the tuple data before splitting.

S1603: Store, in a first storage unit in a storage, all or partial data of the first compressed data page and all or partial data of the second compressed data page.

In a possible implementation, after the first compressed data page and the second compressed data page are obtained, and before all or partial data of the first compressed data page and all or partial data of the second compressed data page are jointly stored in the first storage unit in the storage, the method further includes: splitting the first compressed data page into a first chunk and a second chunk; and splitting the second compressed data page into a third chunk and a fourth chunk; and storing, in the first storage unit in the storage, all or partial data of the first compressed data page and all or partial data of the second compressed data page specifically includes: storing, in the first storage unit in the storage, the first chunk and/or the second chunk, the third chunk and/or the fourth chunk.

Optionally, the first compressed data page and the second compressed data page may be split into more or fewer chunks. This is not limited in this embodiment of this application. A compressed data page is split into chunks, so that a plurality of different compressed data pages may be stored in parallel in the storage, thereby reducing data storage time. In addition, it is convenient to allocate storage space of the storage unit in the storage.

In a possible implementation, storage space of the first storage unit is an integer multiple of a chunk. In this way, it is convenient to allocate storage space of the storage unit in the storage. For example, a size of the chunk is 2 KB or 1 KB, and a size of the storage unit is 4 KB.

In a possible implementation, after the first chunk and/or the second chunk, and the third chunk and/or the fourth chunk are stored in the first storage unit in the storage, the method further includes: storing, in a second storage unit in the storage, a correspondence between the first compressed data page, and a location of the first chunk and a location of the second chunk, and a correspondence between the second compressed data page, and a location of the third chunk and a location of the fourth chunk.

In some embodiments, a location of a chunk may be understood as a direct storage location of the chunk in the storage, that is, a storage location of the chunk in a storage unit in the storage. For example, the location of the chunk may be storage locations of a 1^{st} KB and a 2^{nd} KB in the first storage unit in the storage. For detailed descriptions of this part, refer to descriptions in Table 2 and Table 6. Details are not described herein again in this embodiment of this application.

In some embodiments, a location of a chunk may alternatively be understood as an indirect storage location of the chunk in the storage,
that is, a location of the chunk in an extent in which a compressed data page is located, and a storage location of the extent in which the compressed data page is located in a storage unit in the storage. A plurality of compressed data pages stored in the extent may be obtained based on the storage location of the extent in which the compressed data page is located in the storage unit in the storage, and then a compressed data page corresponding to the chunk is determined based on the location of the chunk in the extent in which the compressed data page is located. For detailed descriptions of this part, refer to descriptions in Table 1, Table 5, and Table 7. Details are not described herein again in this embodiment of this application.

The correspondence may also be referred to as PCA information. The PCA information is stored in the second storage unit in the storage, to facilitate subsequent search for a compressed data page.

The second storage unit may be the storage unit 6 shown in FIG. 13, the second storage unit may be the storage unit 7 shown in FIG. 14, or the second storage unit may be the storage unit 6 shown in FIG. 15.

In a possible implementation, when the first storage unit stores the first chunk and the second chunk, after the first chunk and/or the second chunk, and the third chunk and/or the fourth chunk are stored in the first storage unit in the storage, the method further includes: obtaining a request for managing the first data page, where the request for managing the first data page includes but is not limited to adding data to the first data page, reading data on the first data page, modifying data on the first data page, and deleting and modifying data on the first data page; obtaining, from the second storage unit, an identifier of the first chunk and an identifier of the second chunk that correspond to the first compressed data page; determining the location of the first chunk in the first storage unit based on the identifier of the first chunk, and determining the location of the second chunk in the first storage unit based on the identifier of the second chunk; obtaining the first compressed data page based on the location of the first chunk in the first storage unit and the location of the second chunk in the first storage unit; and decompressing the first compressed data page to obtain the first data page.

When a compressed data page is searched for, a direct storage location of a chunk in the storage or an indirect storage location of the chunk in the storage may be directly found from the PCA information. In this way, the compressed data page is found. This is convenient and fast.

For how to search for the compressed data page based on the PCA information, refer to related descriptions in Table 1 to Table 7. Details are not described herein again in this embodiment of this application.

Based on the data storage method provided in the embodiment in FIG. 16, the following test results may be obtained for database TPC-C data.

**Table 8**

| | | |
|---|---|---|
| Cache size | 350G | 60G |
| Original score | 179232480 | 169486052 |
| Compression score | 175441739 | 160740142 |
| Zstandard score | 174358924 | 154170446 |
| Compression rate | 2.1 to 2.4 | |

In the test results shown in Table 8, the cache size represents running space of a random access memory (random access memory, RAM). The test results are obtained when the running space of the RAM is 350G and 60G separately. The original score refers to an amount of data on which an operation (addition, deletion, query, and modification) can be performed in a database per second when the database is not compressed. The compression score refers to an amount of data on which an operation (addition, deletion, query, and modification) can be performed in a database per second when the database is compressed.

For example, when the running space of the RAM is 350G, the original score of the database is 179232480, the compression score is 175441739, and the Zstandard score is 174358924. When the running space of the RAM is 60G, the original score of the database is 169486052, the compression score is 154170446, and the Zstandard score is 154170446.

It can be learned from Table 8 that the compression rate is between 2.1 and 2.4, and the compression rate may be maintained at more than 2 according to a compression algorithm, so that storage costs of the database can be reduced by half. The score of the database decreases by 2% to 5%, which is generally imperceptible to a user. In this solution, full availability can be achieved, and storage overheads can be reduced.

FIG. 17 is a schematic flowchart of a data storage apparatus according to an embodiment of this application.

In a possible implementation, an apparatus 1700 may include an obtaining unit 1701, a compression unit 1702, and a processing unit 1703. The apparatus 1700 may be configured to perform the data storage method shown in the embodiment in FIG. 16.

The obtaining unit 1701 is configured to obtain a first data page and a second data page in a database.

The compression unit 1702 is configured to compress the first data page and the second data page, to obtain a first compressed data page and a second compressed data page.

The processing unit 1703 is configured to store, in a first storage unit in a storage, all or partial data of the first compressed data page and all or partial data of the second compressed data page.

The apparatus is used, so that one storage unit in the storage can store different compressed data pages, thereby improving utilization of storage space of the storage unit in the storage.

In a possible implementation, the compression unit 1702 is further configured to: split the first compressed data page into a first chunk and a second chunk; and split the second compressed data page into a third chunk and a fourth chunk.

The processing unit 1703 is specifically configured to store, in the first storage unit in the storage, the first chunk and/or the second chunk, and the third chunk and/or the fourth chunk.

Optionally, the first compressed data page and the second compressed data page may be split into more or fewer chunks. This is not limited in this embodiment of this application. A compressed data page is split into chunks, so that a plurality of different compressed data pages may be stored in parallel in the storage, thereby reducing data storage time. In addition, it is convenient to allocate storage space of the storage unit in the storage.

In a possible implementation, storage space of the first storage unit is an integer multiple of a chunk. In this way, it is convenient to allocate storage space of the storage unit in the storage.

In a possible implementation, the processing unit 1703 is further configured to store, in a second storage unit in the storage, a correspondence between the first compressed data page, and a location of the first chunk and a location of the second chunk, and a correspondence between the second compressed data page, and a location of the third chunk and a location of the fourth chunk.

In some embodiments, a location of a chunk may be understood as a direct storage location of the chunk in the storage, that is, a storage location of the chunk in a storage unit in the storage. For example, the location of the chunk may be storage locations of a 1^{st} KB and a 2^{nd} KB in the first storage unit in the storage.

In some embodiments, a location of a chunk may alternatively be understood as an indirect storage location of the chunk in the storage,
that is, a location of the chunk in an extent in which a compressed data page is located, and a storage location of the extent in which the compressed data page is located in a storage unit in the storage. A plurality of compressed data pages stored in the extent may be obtained based on the storage location of the extent in which the compressed data page is located in the storage unit in the storage, and then a compressed data page corresponding to the chunk is determined based on the location of the chunk in the extent in which the compressed data page is located.

The correspondence may also be referred to as PCA information. The PCA information is stored in the second storage unit in the storage, to facilitate subsequent search for a compressed data page.

In a possible implementation, when the first storage unit stores the first chunk and the second chunk, the processing unit 1703 is further configured to: obtain a request for managing the first data page, where the request for managing the first data page includes but is not limited to adding data to the first data page, reading data on the first data page, modifying data on the first data page, and deleting and modifying data on the first data page; obtain, from the second storage unit, an identifier of the first chunk and an identifier of the second chunk that correspond to the first compressed data page; determine the location of the first chunk in the first storage unit based on the identifier of the first chunk, and determine the location of the second chunk in the first storage unit based on the identifier of the second chunk; obtain the first compressed data page based on the location of the first chunk in the first storage unit and the location of the second chunk in the first storage unit; and decompress the first compressed data page to obtain the first data page.

When a compressed data page is searched for, a direct storage location of a chunk in the storage or an indirect storage location of the chunk in the storage may be directly found from the PCA information. In this way, the compressed data page is found. This is convenient and fast.

In a possible implementation, the compression unit 1702 is specifically configured to: split the first data page into a first data part and a second data part; compress the first data part according to a first compression algorithm, to obtain a first compressed data stream; compress the second data part according to a second compression algorithm, to obtain a second compressed data stream; and merge the first compressed data stream and the second compressed data stream, to obtain the first compressed data page, where the first compression algorithm is different from the first compressed data stream.

It should be noted that the first data page may be further split into more data parts. For example, the split data parts further include a third data part and a fourth data part.

Different data on a data page is compressed according to different compression algorithms, so that a compression rate of the data page can be improved.

In a possible implementation, the first data part is metadata, and the second data part is tuple data; the metadata indicates a feature of the first data page, and the tuple data indicates data stored in the first data page; the compression unit 1702 is specifically configured to: compress the metadata according to the first compression algorithm, to obtain the first compressed data stream; and compress the second data part according to the second compression algorithm, to obtain the second compressed data stream; and compressing the second data part according to the second compression algorithm to obtain the second compressed data stream specifically includes: compressing the tuple data according to the second compression algorithm, to obtain the second compressed data stream.

Optionally, the third data part may be free space data, and the fourth data part may be special space data.

Optionally, the first compression algorithm may be an LZ4 compression algorithm, and the second compression algorithm may be the LZ4 compression algorithm or a Huffman compression algorithm.

In a possible implementation, the compression unit 1702 is specifically configured to: split the tuple data into a first part of the tuple data and a second part of the tuple data, where the first part of the tuple data includes the first m bytes of each piece of tuple data, and the second part of the data includes the last n bytes of each piece of tuple data; compress the first part of the tuple data according to the LZ4 compression algorithm, to obtain a first part of compressed tuple data; compress the second part of the tuple data according to the Huffman compression algorithm, to obtain a second part of the compressed tuple data; and merge the first part of the compressed tuple data and the second part of the compressed tuple data, to obtain the second compressed data stream.

The tuple data may be further split into different data, and different data is compressed according to different compression algorithms, so that a compression rate of the tuple data can be improved.

In a possible implementation, the compression unit 1702 is specifically configured to: when the tuple data on the first compressed data page is greater than a first value, split the tuple data into the first part of the tuple data and the second part of the tuple data.

When the tuple data on the first compressed data page is less than the first value, for example, when the tuple data has only one row, it is unnecessary to split the tuple data, and a compression rate of the tuple data after splitting is similar to a compression rate of the tuple data before splitting.

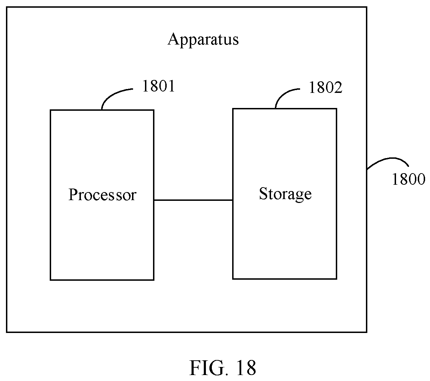

FIG. 18 is a diagram of an apparatus 1800 according to an embodiment of this application.

As shown in FIG. 18, the apparatus includes a processor 1801 and a storage 1802. The apparatus 1800 may be configured to perform the data storage method shown in the embodiment in FIG. 16.

The processor 1801 is coupled to the storage 1802. The storage 1802 is configured to store computer program code. The computer program code includes computer instructions. The processor 1801 invokes the computer instructions to perform the data storage method shown in the embodiment in FIG. 16.

This application provides a computer-readable storage medium, configured to store computer instructions. When the computer instructions are run on a computer, the computer is enabled to perform the data storage method provided in the embodiment in FIG. 16.

This application provides a computer program product. When the computer program product is run on a computer, the computer is enabled to perform the data storage method provided in the embodiment in FIG. 16.

Implementations of this application may be randomly combined to achieve different technical effects.

All or some of the foregoing embodiments may be implemented through software, hardware, firmware, or any combination thereof. When the foregoing embodiments are implemented through the software, all or some of the embodiments may be implemented in a form of a computer program product. The computer program product includes one or more computer instructions. When the computer program instructions are loaded and executed on a computer, procedures or functions according to this application are all or partially generated. The computer may be a general-purpose computer, a dedicated computer, a computer network, or other programmable apparatuses. The computer instructions may be stored in a computer-readable storage medium, or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

A person of ordinary skill in the art may understand that all or some of the processes of the methods in embodiments may be implemented by a computer program instructing relevant hardware. The program may be stored in a computer-readable storage medium. When the program runs, the processes of the methods in embodiments are performed. The foregoing storage medium includes any medium that can store program code, such as a ROM, a random access memory RAM, a magnetic disk, or an optical disc.

In conclusion, the foregoing descriptions are merely embodiments of the technical solutions of the present invention, but are not intended to limit the protection scope of the present invention. Any modification, equivalent replacement, improvement, or the like made according to the disclosure of the present invention shall fall within the protection scope of the present invention.

## Claims

1. A data storage method, wherein the method comprises:
obtaining a first data page and a second data page in a database;
compressing the first data page and the second data page, to obtain a first compressed data page and a second compressed data page; and
storing, in a first storage unit in a storage, all or partial data of the first compressed data page and all or partial data of the second compressed data page.

2. The method according to claim 1, wherein after the first compressed data page and the second compressed data page are obtained, and before the jointly storing, in a first storage unit in a storage, all or partial data of the first compressed data page and all or partial data of the second compressed data page, the method further comprises:
splitting the first compressed data page into a first chunk and a second chunk; and
splitting the second compressed data page into a third chunk and a fourth chunk; and
the storing, in a first storage unit in a storage, all or partial data of the first compressed data page and all or partial data of the second compressed data page specifically comprises:
storing, in the first storage unit in the storage, the first chunk and/or the second chunk, and the third chunk and/or the fourth chunk.

3. The method according to claim 2, wherein storage space of the first storage unit is an integer multiple of a chunk.

4. The method according to claim 2 or 3, wherein after the storing, in the first storage unit in the storage, the first chunk and/or the second chunk, and the third chunk and/or the fourth chunk, the method further comprises:
storing, in a second storage unit in the storage, a correspondence between the first compressed data page, and a location of the first chunk and a location of the second chunk, and a correspondence between the second compressed data page, and a location of the third chunk and a location of the fourth chunk.

5. The method according to claim 4, wherein when the first storage unit stores the first chunk and the second chunk, after the storing, in the first storage unit in the storage, the first chunk and/or the second chunk, and the third chunk and/or the fourth chunk, the method further comprises:
obtaining a request for managing the first data page, wherein the request for managing the first data page comprises but is not limited to adding data to the first data page, reading data on the first data page, modifying data on the first data page, and deleting and modifying data on the first data page;
obtaining, from the second storage unit, an identifier of the first chunk and an identifier of the second chunk that correspond to the first compressed data page;
determining the location of the first chunk in the first storage unit based on the identifier of the first chunk, and determining the location of the second chunk in the first storage unit based on the identifier of the second chunk;
obtaining the first compressed data page based on the location of the first chunk in the first storage unit and the location of the second chunk in the first storage unit; and
decompressing the first compressed data page to obtain the first data page.

6. The method according to any one of claims 1 to 5, wherein the compressing the first data page to obtain a first compressed data page specifically comprises:
splitting the first data page into a first data part and a second data part;
compressing the first data part according to a first compression algorithm, to obtain a first compressed data stream;
compressing the second data part according to a second compression algorithm, to obtain a second compressed data stream; and
merging the first compressed data stream and the second compressed data stream, to obtain the first compressed data page, wherein
the first compression algorithm is different from the first compressed data stream.

7. The method according to claim 6, wherein the first data part is metadata, and the second data part is tuple data; and the metadata indicates a feature of the first data page, and the tuple data indicates data stored in the first data page;
the compressing the first data part according to a first compression algorithm, to obtain a first compressed data stream specifically comprises:
compressing the metadata according to the first compression algorithm, to obtain the first compressed data stream; and
the compressing the second data part according to a second compression algorithm, to obtain a second compressed data stream specifically comprises:
compressing the tuple data according to the second compression algorithm, to obtain the second compressed data stream.

8. The method according to claim 7, wherein the compressing the tuple data according to the second compression algorithm, to obtain the second compressed data stream specifically comprises:
splitting the tuple data into a first part of the tuple data and a second part of the tuple data, wherein the first part of the tuple data comprises first m bytes of each piece of tuple data, and the second part of the data comprises last n bytes of each piece of tuple data;
compressing the first part of the tuple data according to the LZ4 compression algorithm, to obtain a first part of compressed tuple data;
compressing the second part of the tuple data according to the Huffman compression algorithm, to obtain a second part of the compressed tuple data; and
merging the first part of the compressed tuple data and the second part of the compressed tuple data, to obtain the second compressed data stream.

9. The method according to claim 8, wherein the splitting the tuple data into a first part of the tuple data and a second part of the tuple data specifically comprises:
when the tuple data on the first compressed data page is greater than a first value, splitting the tuple data into the first part of the tuple data and the second part of the tuple data.

10. A data storage apparatus, wherein the apparatus comprises an obtaining unit, a compression unit, and a processing unit;
the obtaining unit is configured to obtain a first data page and a second data page in a database;
the compression unit is configured to compress the first data page and the second data page, to obtain a first compressed data page and a second compressed data page; and
the processing unit is configured to store, in a first storage unit in a storage, all or partial data of the first compressed data page and all or partial data of the second compressed data page.

11. The apparatus according to claim 10, wherein the compression unit is further configured to: split the first compressed data page into a first chunk and a second chunk; and
split the second compressed data page into a third chunk and a fourth chunk; and
the processing unit is specifically configured to store, in the first storage unit in the storage, the first chunk and/or the second chunk, and the third chunk and/or the fourth chunk.

12. The apparatus according to claim 11, wherein storage space of the first storage unit is an integer multiple of a chunk.

13. The apparatus according to claim 11 or 12, wherein the processing unit is further configured to store, in a second storage unit in the storage, a correspondence between the first compressed data page, and a location of the first chunk and a location of the second chunk, and a correspondence between the second compressed data page, and a location of the third chunk and a location of the fourth chunk.

14. The apparatus according to claim 13, wherein when the first storage unit stores the first chunk and the second chunk, the processing unit is further configured to: obtain a request for managing the first data page, wherein the request for managing the first data page comprises but is not limited to adding data to the first data page, reading data on the first data page, modifying data on the first data page, and deleting and modifying data on the first data page;
obtain, from the second storage unit, an identifier of the first chunk and an identifier of the second chunk that correspond to the first compressed data page;
determine the location of the first chunk in the first storage unit based on the identifier of the first chunk, and determine the location of the second chunk in the first storage unit based on the identifier of the second chunk;
obtain the first compressed data page based on the location of the first chunk in the first storage unit and the location of the second chunk in the first storage unit; and
decompress the first compressed data page to obtain the first data page.

15. The apparatus according to any one of claims 10 to 14, wherein the compression unit is specifically configured to:
split the first data page into a first data part and a second data part;
compress the first data part according to a first compression algorithm, to obtain a first compressed data stream;
compress the second data part according to a second compression algorithm, to obtain a second compressed data stream; and
merge the first compressed data stream and the second compressed data stream, to obtain the first compressed data page, wherein
the first compression algorithm is different from the first compressed data stream.

16. The apparatus according to claim 15, wherein the first data part is metadata, and the second data part is tuple data; and the metadata indicates a feature of the first data page, and the tuple data indicates data stored in the first data page;
the compression unit is specifically configured to compress the metadata according to the first compression algorithm, to obtain the first compressed data stream; and
the compression unit is specifically configured to compress the tuple data according to the second compression algorithm, to obtain the second compressed data stream.

17. The apparatus according to claim 16, wherein the compression unit is specifically configured to: split the tuple data into a first part of the tuple data and a second part of the tuple data, wherein the first part of the tuple data comprises first m bytes of each piece of tuple data, and the second part of the data comprises last n bytes of each piece of tuple data;
compress the first part of the tuple data according to the LZ4 compression algorithm, to obtain a first part of compressed tuple data;
compress the second part of the tuple data according to the Huffman compression algorithm, to obtain a second part of the compressed tuple data; and
merge the first part of the compressed tuple data and the second part of the compressed tuple data, to obtain the second compressed data stream.

18. The apparatus according to claim 17, wherein the compression unit is specifically configured to: when the tuple data on the first compressed data page is greater than a first value, split the tuple data into the first part of the tuple data and the second part of the tuple data.

19. A data storage apparatus, wherein the apparatus comprises a processor and a storage, the storage is coupled to the processor, the storage is configured to store computer program code, the computer program code comprises computer instructions, and the processor invokes the computer instructions to perform the method according to any one of claims 1 to 9.

20. A computer-readable storage medium, configured to store computer instructions, wherein when the computer instructions are run on a computer, the computer is enabled to perform the method according to any one of claims 1 to 9.

21. A computer program product, wherein when the computer program product runs on a computer, the computer is enabled to perform the method according to any one of claims 1 to 9.
